# EUROPEAN PATENT SPECIFICATION

(11) **EP 4 475 640 B1**
(45) Date of publication and mention of the grant of the patent: **11.02.2026**
(21) Application number: 24718695.0
(22) Date of filing: 09.04.2024
(51) Int. Cl.: G06F 1/16, H04M 1/02, H01Q 1/44, H01Q 21/28, H01Q 1/24, H01Q 9/42

(54) **ELECTRONIC DEVICE COMPRISING HOUSING**
ELEKTRONISCHE VORRICHTUNG MIT GEHÄUSE
DISPOSITIF ÉLECTRONIQUE COMPRENANT UN BOÎTIER

(30) Priority: 24.04.2023 KR 20230053339; 20.07.2023 KR 20230094855
(43) Date of publication of application: 11.12.2024
(73) Proprietor: Samsung Electronics Co., Ltd., Suwon-si, Gyeonggi-do 16677 (KR)
(72) Inventor: HAN, Yunjae, Suwon-si, Gyeonggi-do 16677 (KR); KANG, Hyeonuk, Suwon-si, Gyeonggi-do 16677 (KR); KIM, Soojung, Suwon-si, Gyeonggi-do 16677 (KR); KIM, Yongyoun, Suwon-si, Gyeonggi-do 16677 (KR); OH, Chanhee, Suwon-si, Gyeonggi-do 16677 (KR)
(74) Representative: Nederlandsch Octrooibureau
(86) International application number: PCT/KR2024/004753
(87) International publication number: WO 2024/225661

(56) References cited:
- KR-A- 20220 098 598
- KR-A- 20220 102 536
- KR-B1- 101 622 503
- KR-B1- 101 721 877
- KR-B1- 102 316 429
- US-A1- 2018 026 337

## Description

### [TECHNICAL FIELD]

Various embodiments disclosed in the disclosure relate to an electronic device including a housing.

### [BACKGROUND ART]

With the development of the digital technology, various electronic devices that may communicate and process personal information while moving, such as mobile communication terminals, electronic notebooks, smart phones, tablet PCs, and wearable devices, are being released. Through the rapid technological development, the electronic devices have come to be equipped with various functions, such as video calls, electronic notebook functions, document functions, e-mail functions, and Internet functions, including simple voice calls and message transmission functions.

An electronic device may use a part of the housing as an antenna. For example, a housing of an electronic device may include a conductive area and a non-conductive area, which correspond to dissimilar materials, and the conductive area of the housing may be used as an antenna.

The above-described housing of dissimilar materials may be formed by insert-molding the non-conductive material into the conductive material, but it may be vulnerable to impacts. For example, due to an impact applied to the housing formed of dissimilar materials, the joining of the conductive area and the non-conductive area may be released, and this deteriorate a strength and a quality of the electronic device.

US2018/026337A1 discloses an antenna structure that includes a metallic member including a front frame and a side frame. The side frame defines a slot. The front frame defines a second gap and a third gap communicating with the slot and extending across the front frame. A portion of the front frame between the second gap and the third gap forms a first radiating section.

### [DETAILED DESCRIPTION OF THE INVENTION]

### [TECHNICAL PROBLEM]

A part of the above-described housing may be provided with a reinforced structure for strengthening the jointing of the dissimilar materials.

In general, the reinforced structure may be formed in the conductive area of the housing and may have a shape that protrudes toward the interior of the electronic device. Additionally, at least one aperture for injection may be formed in the reinforced structure that extends toward the interior of the electronic device. Accordingly, when the non-conductive material is insert-molded into the conductive material, the aperture for injection is filled with the non-conductive material, so that a joining force of the conductive area and the non-conductive area, which correspond to the dissimilar materials, may be strengthened.

However, when the reinforced structure is formed in the conductive area used as an antenna, a spacing distance between the reinforced structure and the components (e.g., a conductive structure, such as a metal part and a metal mechanism) in the interior of the electronic device is not secured at a specific level or higher by that reinforced structure that protrudes toward an interior of the electronic device whereby a performance of the antenna may deteriorate.

Accordingly, at least one example of various embodiments is to provide an electronic device that improves a performance of an antenna while strengthening a joining force of dissimilar materials of a housing.

### [TECHNICAL SOLUTION]

The invention is defined in the appended claims.

### [ADVANTAGEOUS EFFECTS OF THE INVENTION]

According to the electronic device according to various embodiments disclosed in the disclosure, a spacing distance between the reinforced structure and the components in the interior of the electronic device may be secured at a specific level or higher by making the arrangement of, among the plurality of reinforced structures included in the housing, at least one reinforced structure different whereby the performance of the antenna may be improved while the joining force of the dissimilar materials of the housing may be strengthened.

The effects that may be obtained from the disclosure are not limited to those mentioned above.

### [DESCRIPTION OF THE DRAWINGS]

FIG. 1 is a block diagram of an electronic device in a network environment according to various embodiments.
FIG. 2A is a view illustrating an exterior of an electronic device according to various embodiments.
FIG. 2B is an exploded perspective view of the electronic device illustrated in FIG. 1.
FIG. 2C is a view illustrating another exterior of an electronic device according to various embodiments.
FIG. 2D is an exploded perspective view of the electronic device illustrated in FIG. 2C.
FIG. 3A is a view illustrating an interior of an electronic device including a reinforced structure.
FIG. 3B is a view illustrating a reinforced structure.
FIG. 3C is a cross-sectional view taken along line A-A' in FIG. 3A.
FIG. 4A is a view illustrating a projection of an interior of an electronic device including a reinforced structure according to various embodiments.
FIG. 4B is a view illustrating a reinforced structure according to various embodiments.
FIG. 4C is a view illustrating a housing, in which a non-conductive material is insert-molded, according to various embodiments.
FIG. 5A is a view illustrating internal components of an electronic device.
FIGS. 5B and 5C are views illustrating an arrangement of a reinforced structure according to various embodiments.
FIGS. 5D and 5E are other views illustrating an arrangement of a reinforced structure according to various embodiments.
FIG. 5F is a view illustrating a spacing distance between a reinforced structure and internal components of an electronic device according to various embodiments.
FIGS. 6A to 6F are views illustrating a shape of a reinforced structure according to various embodiments.
FIGS. 7A and 7D illustrate electronic devices, to which various embodiments are applied.
FIGS. 8A and 8B illustrate other electronic devices, to which various embodiments are applied.

In relation to a description of the drawings, identical or similar reference numerals may be used for identical or similar components.

### [MODE OF INVENTION]

Hereinafter, various embodiments of the disclosure will be described with reference to the accompanying drawings. However, this is not intended to limit the technology described in the disclosure to specific embodiments, and should be understood to include various modifications, equivalents, and/or alternatives to the embodiments of the disclosure. In relation to the description of the drawings, similar reference numbers may be used for similar components.

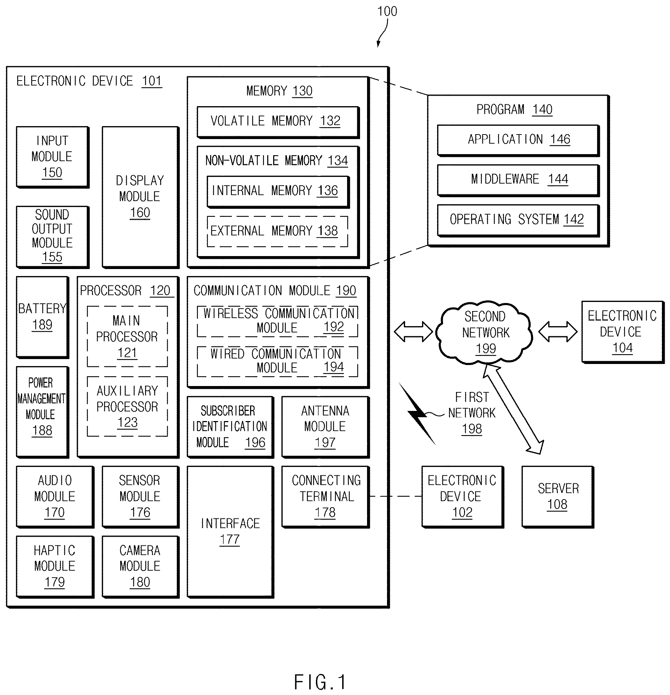

FIG. 1 is a block diagram of an electronic device 101 in a network environment 100 according to various embodiments. Referring to FIG. 1, in the network environment 100, the electronic device 101 may communicate with an electronic device 102 through a first network 198 (e.g., a short-range wireless communication network), or may communicate with at least one of an electronic device 104 or a server 108 through a second network 199 (e.g., a long-distance wireless communication network). According to an embodiment, the electronic device 101 may communicate with the electronic device 104 through the server 108. According to an embodiment, the electronic device 101 may include a processor 120, a memory 130, an input module 150, an audio output module 155, a display module 160, an audio module 170, and a sensor module 176, an interface 177, a connection terminal 178, a haptic module 179, a camera module 180, a power management module 188, a battery 189, a communication module 190, a subscriber identification module 196, or an antenna module 197. In some embodiments, at least one (e.g., the connection terminal 178) of the components may be omitted or one or more other components may be added to the electronic device 101. In some embodiments, some of the components (e.g., sensor module 176, camera module 180, or antenna module 197) are integrated into one component (e.g., display module 160).

The processor 120, for example, may execute software (e.g., a program 140) to control at least one other component (e.g., a hardware or software component) of the electronic device 101, which is connected to the processor 120, and various data processing or computation may be performed. According to an embodiment, as at least a part of data processing or computation, the processor 120 may store instructions or data received from another component (e.g., the sensor module 176 or the communication module 190) in a volatile memory 132, and the commands or data stored in the volatile memory 132 may be processed, and the resulting data may be stored in a non-volatile memory 134. According to an embodiment, the processor 120 may include a main processor 121 (e.g., a central processing unit or an application processor) or an auxiliary processor 123 (e.g., a graphics processing unit, a neural network processing unit (NPU), an image signal processor, a sensor hub processor, or a communication processor) that may be operated independently therefrom or together therewith. For example, when the electronic device 101 includes the main processor 121 and the auxiliary processor 123, the auxiliary processor 123 may be set to use lower electric power than that of the main processor 121 or be specialized for a designated function. The auxiliary processor 123 may be implemented separately from or as a part of the main processor 121.

The auxiliary processor 123 may, for example, replace the main processor 121 while the main processor 121 is in an inactive (e.g., sleep) state, or control at least some of functions or states related to at least one (e.g., the display module 160, the sensor module 176, or the communication module 190) of the components of the electronic device 101, together with the main processor 121 while the main processor 121 is in an active (e.g., execution of an application) state. According to an embodiment, the auxiliary processor 123 (e.g., an image signal processor or a communication processor) may be implemented as a part of another component (e.g., the camera module 180 or the communication module 190) functionally related thereto. According to an embodiment, the auxiliary processor 123 (e.g., a neural network processing device) may include a hardware structure that is specialized for processing artificial intelligence models. The artificial intelligence models may be created through machine learning. For example, such learning may be performed in the electronic device 101 itself, on which the artificial intelligence model is performed, or may be performed through a separate server (e.g., the server 108). Learning algorithms may, for example, include supervised learning, unsupervised learning, semi-supervised learning, or reinforcement learning, but are not limited thereto. An artificial intelligence model may include a plurality of artificial neural network layers. Artificial neural networks include a deep neural network (DNN), a convolutional neural network (CNN), a recurrent neural network (RNN), a restricted Boltzmann machine (RBM), a deep belief network (DBN), a bidirectional recurrent deep neural network (BRDNN), or a deep Q-network, or a combination of two or more of the above, but are not limited to the examples described above. In addition to a hardware structure, additionally or alternatively, an artificial intelligence model may include a software structure.

The memory 130 may store various data that are used by at least one component (e.g., the processor 120 or the sensor module 176) of the electronic device 101. The data may include, for example, input data or output data for software (e.g., the program 140), and instructions related thereto. The memory 130 may include a volatile memory 132 or a non-volatile memory 134.

The program 140 may be stored as software in the memory 130, and may include, for example, an operating system 142, middleware 144, or an application 146.

The input module 150 may receive instructions or data that are to be used in a component (e.g., the processor 120) of the electronic device 101 from an outside (e.g., a user) of the electronic device 101. The input module 150 may include, for example, a microphone, a mouse, a keyboard, a keys (e.g., buttons), or a digital pen (e.g., a stylus pen).

The audio output module 155 may output sound signals to the outside of the electronic device 101. The audio output module 155 may include, for example, a speaker or a receiver. The speaker may be used for general purposes, such as multimedia playback or recording playback. The receiver may be used to receive incoming calls. According to an embodiment, the receiver may be implemented separately from or as part of the speaker.

The display module 160 may visually provide information to the outside (e.g., the user) of the electronic device 101. The display module 160 may include, for example, a display, a hologram device, or a projector, and a control circuit for controlling the device. According to an embodiment, the display module 160 may include a touch sensor configured to detect a touch, or a pressure sensor configured to measure an intensity of a force that is generated by the touch.

The audio module 170 may convert sound into electrical signals or, conversely, convert electrical signals into sound. According to an embodiment, the audio module 170 may acquire sound through the input module 150, may output sound through the audio output module 155, or an external electronic device (e.g., the electronic device 102) (e.g., a speaker or a headphone) connected directly or wirelessly to the electronic device 101).

The sensor module 176 may detect an operating state (e.g., electric power or a temperature) of the electronic device 101 or an external environmental state (e.g., a user state), and may generate an electrical signal or a data value corresponding to the detected state. According to an embodiment, the sensor module 176 includes, for example, a gesture sensor, a gyro sensor, an air pressure sensor, a magnetic sensor, an acceleration sensor, a grip sensor, a proximity sensor, a color sensor, an infrared (IR) sensor, a biometric sensor, a temperature sensor, a humidity sensor, or an illumination sensor.

The interface 177 may support one or more designated protocols that may be used to connect the electronic device 101 to an external electronic device (e.g., the electronic device 102) directly or wirelessly. According to an embodiment, the interface 177 may include, for example, a high definition multimedia interface (HDMI), a universal serial bus (USB) interface, an SD card interface, or an audio interface.

The connection terminal 178 may include a connector, through which the electronic device 101 may be physically connected to an external electronic device (e.g., the electronic device 102). According to an embodiment, the connection terminal 178 may include, for example, an HDMI connector, a USB connector, an SD card connector, or an audio connector (e.g., a headphone connector).

The haptic module 179 may convert electrical signals into a mechanical stimulus (e.g., vibration or a motion) or an electrical stimulus that the user may perceive through tactile or kinesthetic senses. According to an embodiment, the haptic module 179 may include, for example, a motor, a piezoelectric element, or an electrical stimulation device.

The camera module 180 may capture still images and videos. According to an embodiment, the camera module 180 may include one or more lenses, image sensors, image signal processors, or flashes.

The power management module 188 may manage electric power that is supplied to the electronic device 101. According to an embodiment, the power management module 188 may be implemented, for example, as at least a part of a power management integrated circuit (PMIC).

The battery 189 may supply electric power to at least one component of the electronic device 101. According to an embodiment, the battery 189 may include, for example, a non-rechargeable primary battery, a rechargeable secondary battery, or a fuel cell.

The communication module 190 may support establishment of a direct (e.g., wired) communication channel or a wireless communication channel between the electronic device 101 and an external electronic device (e.g., the electronic device 102, the electronic device 104, or the server 108), and communication through the established communication channel. The communication module 190 is operated independently of the processor 120 (e.g., an application processor), and may include one or more communication processors that support direct (e.g., wired) communication or wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module, or a power line communication module). Among the communication modules, the corresponding communication module may communicate with the external electronic device 104 through a first network 198 (e.g., a short-range communication network, such as Bluetooth, wireless fidelity (Wi-Fi) direct, or infrared data association (IrDA)) or a second network 199 (e.g., a long-range communication network, such as a legacy cellular network, a 5G network, a next-generation communication network, the Internet, or a computer network (e.g., LAN or WAN)). These various types of communication modules may be integrated into one component (e.g., a single chip) or may be implemented as a plurality of separate components (e.g., multiple chips). The wireless communication module 192 may identify or authenticate the electronic device 101 in a communication network, such as the first network 198 or the second network 199 by using subscriber information (e.g., international mobile subscriber identifier (IMSI)) stored in the subscriber identification module 196.

The wireless communication module 192 may support 5G networks after 4G networks and next-generation communication technologies, for example, a new radio (NR) access technology). The NR access technology may support high-speed transmission of high-capacity data (enhanced mobile broadband (eMBB)), minimization of terminal power and access to multiple terminals (massive machine type communications (mMTC)), or high reliability and low latency (ultra-reliable and low latency communications (URLLC)). The wireless communication module 192 may support a high frequency band (e.g., a mmWave band), for example, to achieve a high data transfer rate. The wireless communication module 192 may support various technologies for securing performance in high frequency bands, for example, beamforming, massive array multiple-input and multiple-output (MIMO), and full-dimensional MIMO (FD-MIMO), an array antenna, analog beam-forming, or a large-scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20 Gbps or more) for realizing eMBB, a loss coverage (e.g., 164 dB or less) for realizing mMTC, or a U-plane latency (e.g., 164 dB or less) for realizing URLLC (e.g., 0.5 ms or less for each of a downlink (DL) and an uplink (UL), or a round trip of 1 ms or less).

The antenna module 197 may transmit signals or power to or receive signals or power from an outside (e.g., an external electronic device). According to an embodiment, the antenna module 197 may include an antenna including a radiator formed of a conductor or a conductive pattern that is formed on a substrate (e.g., a PCB). According to an embodiment, the antenna module 197 may include a plurality of antennas (e.g., array antennas). In this case, at least one antenna that is suitable for a communication method used in a communication network, such as the first network 198 or the second network 199, may be selected from the plurality of antennas by, for example, the communication module 190. Signals or electric power may be transmitted or received between the communication module 190 and an external electronic device through the at least one selected antenna. According to some embodiments, in addition to the radiator, another part (e.g., a radio frequency integrated circuit (RFIC)) may be additionally formed as a part of the antenna module 197.

According to various embodiments, the antenna module 197 may form a mmWave antenna module. According to an embodiment, the mmWave antenna module includes a printed circuit board, an RFIC that is placed on or adjacent to a first surface (e.g., a lower surface) of the printed circuit board and may support a designated high frequency band (e.g., a mmWave band), and a plurality of antennas (e.g., array antennas) that are placed on or adjacent to a second surface (e.g., an upper surface or a side surface) of the printed circuit board and may transmit or receive signals in the designated high frequency band.

At least some of the components may be connected to each other through a communication method between peripheral devices (e.g., a bus, a general purpose input and output (GPIO), a serial peripheral interface (SPI), or a mobile industry processor interface (MIPI)) and may exchange signals (e.g., instructions or data) therebetween.

According to an embodiment, instructions or data may be transmitted or received between the electronic device 101 and the external electronic device 104 through the server 108 connected to the second network 199. Each of the external electronic devices 102 or 104 may be of a type that is the same as or different from the electronic device 101. According to an embodiment, all or some of the operations performed in the electronic device 101 may be executed in one or more external electronic devices of the external electronic devices 102, 104, or 108. For example, when the electronic device 101 has to perform a certain function or service automatically or in response to a request from the user or another device, the electronic device 101 may request the one or more external devices to perform the function or service instead of executing the function or service on its own or selectively. One or more external electronic devices that have received the request may execute at least a part of the requested function or service, or an additional function or service related to the request, and may transmit the result of the execution to the electronic device 101. The electronic device 101 may process the result as it is or selectively and provide it as at least a part of a response to the request. For this purpose, for example, the cloud computing, distributed computing, mobile edge computing (MEC), or client-server computing technology may be used. The electronic device 101 may provide an ultra-low latency service by using, for example, distributed computing or mobile edge computing. In another embodiment, the external electronic device 104 may include an Internet of Things (IoT) device. The server 108 may be an intelligent server using machine learning and/or neural networks. According to an embodiment, the external electronic device 104 or the server 108 may be included in the second network 199. The electronic device 101 may be applied to intelligent services (e.g., a smart home, a smart city, a smart car, or a healthcare) based on the 5G communication technology and the loT-related technology.

The electronic device according to various embodiments disclosed in the disclosure may be device of various types. The electronic device may include, for example, a portable communication device (e.g., a smartphone), a computer device, a portable multimedia device, a portable medical device, a camera, a wearable device, or a home appliance. The electronic device according to embodiments of the disclosure are not limited to the devices described above.

The various embodiments of the disclosure and the terms used therein are not intended to limit the technical features described in the disclosure to specific embodiments, and should be understood to include various modifications, equivalents, or replacements of the embodiments. In relation to the description of the drawings, similar reference numbers may be used for similar or related components. The singular form of a noun corresponding to an item may include one or more of the above items, unless the relevant context clearly indicates otherwise. In the disclosure, each of the phrases, such as "A or B", "at least one of A and B", "at least one of A or B", "at least one of A, B or C", or "at least one of A, B and C", may include any one of the items listed together in the corresponding phrase, or any possible combination thereof. The terms, such as "a first" or "a second", or "the first" or "the second" may be used simply to distinguish one component from another, the corresponding component are not limited in another aspect. When it is mentioned that one (e.g., first) component is "coupled" or "connected" to another (e.g., second) component, together with or without the terms "functionally" or "communicatively", it means that any of the components may be connected to the other component directly (e.g., wired), wirelessly, or through a third component.

The term "module" used in various embodiments of the disclosure may include a unit that is implemented in hardware, software, or firmware, and, for example, may be used to be interchangeable with terms, such as logic, a logic block, a part, or a circuit. A module may be an integrated part or a minimum unit of the parts or a part thereof that performs one or more functions. For example, according to an embodiment, the module may be implemented in the form of an application-specific integrated circuit (ASIC).

Various embodiments of the disclosure may be implemented as software (e.g., the program 140) including one or more instructions that are stored in a storage medium (e.g., an internal memory 136 or an external memory 138) that may be read by a machine (e.g., the electronic device 101). For example, the processor (e.g., the processor 120) of the device (e.g., the electronic device 101) may call at least one of one or more stored instructions from a storage medium and may execute it. This allows the device to be operated to perform at least one function according to the at least one instruction called. This allows the device to be operated to perform at least one function according to the at least one called instruction. The one or more instructions may include codes that are generated by a compiler or codes that may be executed by an interpreter. The storage medium that may be read by the device may be provided in the form of a non-transitory storage medium. Here, 'non-transitory' only means that the storage medium is a tangible device and does not contain signals (e.g., electromagnetic waves), and this term does not distinguish a case, in which data is stored semi-permanently in the storage medium, and a case, in which they are stored temporarily.

According to an embodiment, the method according to various embodiments disclosed in the disclosure may be included and provided in a computer program product. The computer program product may be traded between sellers and buyers as a product. The computer program product may be distributed in the form of a machine-readable storage medium (e.g., compact disc read only memory (CD-ROM)), or may be distributed (e.g., downloaded or uploaded) directly or online through an application store (e.g., Play Store^{™}), or between two user devices (e.g., smartphones). In the case of the online distribution, at least some of the computer program products may be at least temporarily stored or temporarily created in a machine-readable storage medium, such as a memory of a server of a manufacturer, a server of an application store, or a relay server.

According to various embodiments, each (e.g., modules or programs) of the above-described components may include a single or plural entities, and some of the plurality of entities may be separately placed in other components. According to various embodiments, one or more of the components or operations described above may be omitted, or one or more other components or operations may be added. Alternatively or selectively, a plurality of components (e.g., modules or programs) may be integrated into one component. In this case, the integrated component may perform one or more functions of each of the plurality of components in the same or similar manner as those performed by the corresponding one of the plurality of components prior to the integration. According to various embodiments, operations performed by a module, a program, or another component may be executed sequentially, in parallel, iteratively, or heuristically, or one or more of the operations may be executed in a different order, omitted, or one or more other operations may be added.

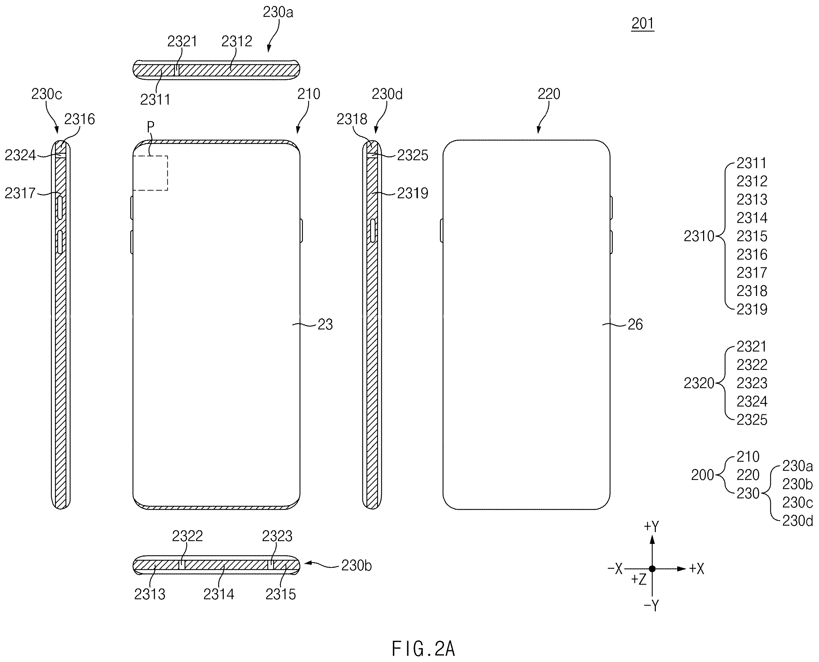

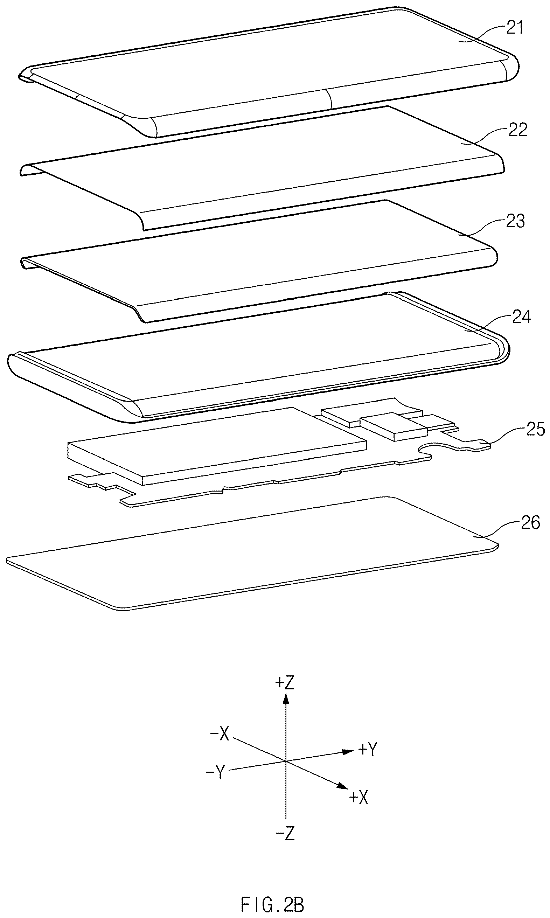

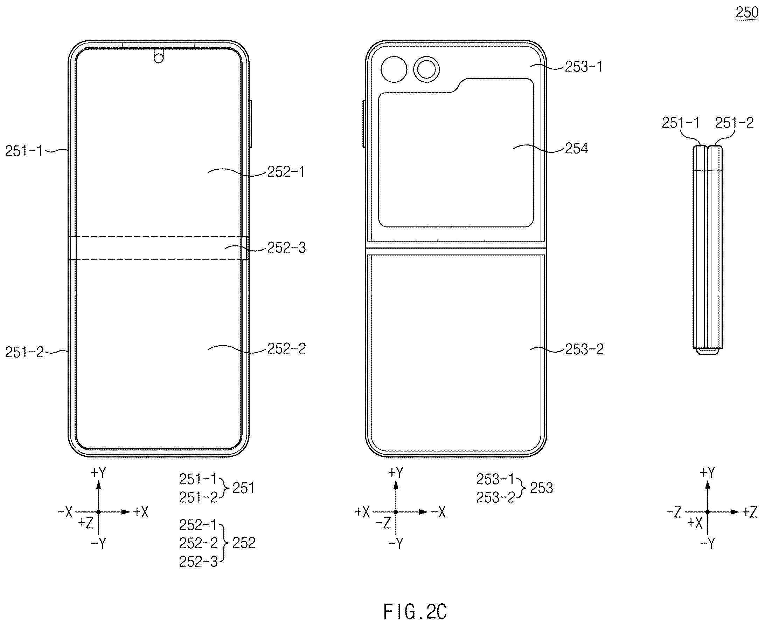

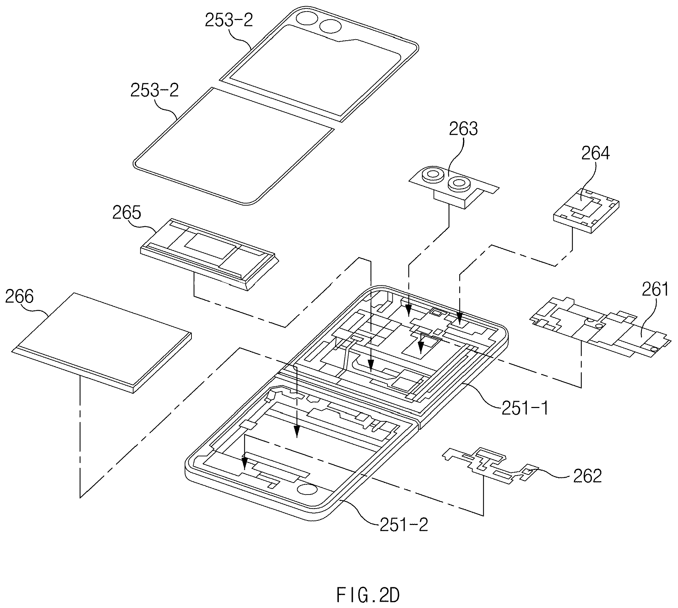

FIG. 2A is a view illustrating an exterior of an electronic device according to various embodiments. Furthermore, FIG. 2B is an exploded perspective view of the electronic device illustrated in FIG. 1, FIG. 2C is a view illustrating another exterior of the electronic device according to various embodiments, and FIG. 2D is an exploded perspective view of the electronic device illustrated in FIG. 2C.

Referring to FIGS. 2A and 2B, an electronic device 201 (e.g., the electronic device 101 of FIG. 1) according to various embodiments includes a housing 200 that accommodates various components and forms the exterior of the electronic device 201. For example, various components including a hardware component 25 that will be described later with reference to FIG. 2B may be accommodated in the housing 200 of the electronic device 201.

According to the invention, the housing 200 includes a front surface 210, a rear surface 220, and a side surface 230 that surrounds a space between the front surface 210 and the rear surface 220. In various embodiments below, the front surface 210, the rear surface 220, and the side surface 230 of the housing 200 may be interpreted as the front surface, rear surface, and side surface of the electronic device 101, respectively.

According to various embodiments, at least a portion of the front surface 210 of the housing 200 may be defined by a substantially transparent front plate 21. According to an embodiment, the front surface 210 may include a glass plate or a polymer plate including various coating layers.

According to various embodiments, the rear surface 220 of the housing 200 may be defined by a substantially opaque rear plate 26. According to an embodiment, the rear surface 220 may be formed of coated or colored glass, ceramic, polymer, metal (e.g., aluminum, stainless steel (STS), or magnesium), or a combination of at least two thereof.

According to an embodiment, at least one end of the front surface 210 may include a curved surface portion that is bent from the front surface 210 toward the rear surface 220 (e.g., the rear plate 26) and extends seamlessly. Furthermore, at least one end of the rear surface 220 may include a curved surface portion that is curved from the rear surface 220 toward the front surface 210 (e.g., front plate 21) and extends seamlessly.

According to various embodiments, the side surface 230 may be defined by a side plate 24 that couples the front surface 210 (e.g., the front plate 21) and the rear surface 220 (e.g., the rear plate 26). For example, the side surface 230 may include a first side surface 230a (e.g., an upper surface), a second side surface 230b (e.g., a lower surface), and a third side surface 230c (e.g., a left side surface), and a fourth side surface 230d (e.g., a right side surface).

According to various embodiments, at least a portion of the housing 200 may be formed of dissimilar materials. The dissimilar materials may include a conductive material and a non-conductive material.

According to the invention, the side surface 230 (e.g., at least one of the first side surface 230a to the fourth side surface 230d) includes at least one conductive area 2310 formed of a conductive material, and at least one non-conductive area 2320 formed of a non-conductive material. For example, the conductive area 2310 and the non-conductive area 2320 may be formed by insert-molding a non-conductive material into the side plate 24 of the conductive material. For example, the conductive area 2310 may be formed of a metal material (e.g., one of aluminum, stainless steel, magnesium, or a combination of two or more thereof), and the non-conductive area 2320 may be formed of a synthetic resin material.

According to various embodiments, at least a portion of the housing 200 may perform an antenna function. For example, at least one conductive area 2310 may be electrically connected to an antenna module (e.g., the antenna module 197 in FIG. 1) to transmit or receive electromagnetic waves.

According to an embodiment, the side surface 230 of the housing 200 may include a plurality of conductive areas 2310 that are spaced apart from each other to be used as antennas.

For example, as illustrated in FIG. 2A, the first side surface 230a may have a first conductive area 2311, a second conductive area 2312, and a divided structure, in which a first non-conductive area 2321 is placed therebetween, and the second side surface 230b may include a second non-conductive area 2322 and a third non-conductive area 2323, and a third conductive area 2313, a fourth conductive area 2314, and a fifth conductive area 2315 that are separated thereby.

Furthermore, the third side surface 230c may have a sixth conductive area 2316 and a seventh conductive area 2317, and a divided structure, in which a fourth non-conductive area 2324 is placed therebetween, and the fourth side surface 230d may have a seventh conductive area 2318 and an eighth conductive area 2319, and a divided structure, in which a fifth non-conductive area 2325 are placed therebetween.

The structural features of the side surface 230 described above are only one example, and various embodiments are not limited thereto. For example, one side surface of at least one of the first to fourth side surfaces 230a to 230d may be formed only as the conductive area 2310 (or the non-conductive area 2320), and at least a portion of the conductive area 2310 and/or a portion of the non-conductive area 2320 may be formed as at least a portion of the front surface 210 and/or rear surface 220 of the housing 200.

According to various embodiments, the electronic device 201, as illustrated in FIG. 2B, may include a front plate 21, an adhesive layer 22, a display 23 (e.g., the display module 160 of FIG. 1), a side plate 24, a hardware component 25, and a rear plate 26. According to an embodiment, the front plate 21, the side plate 24, and the rear plate 26 may be interpreted as the housing 200 of the electronic device 201.

According to various embodiments, the front plate 21 may be an external protective layer that protects an exterior of the display 23. The front plate 21 may be formed of a transparent material, such as a glass material or a polymer material. In various embodiments, the front plate 21 may be interpreted as the front surface 210 of the housing 200.

According to various embodiments, the adhesive layer 22 may adhere the front plate 21 and the display 23. The adhesive layer 22 may be formed of an optically transparent adhesive layer (an optical clear adhesive).

According to various embodiments, the display 23 may be placed to occupy at least a portion of the front surface 210 of the electronic device 201. According to an embodiment, the display 23 may include at least one pixel. For example, the side surface of the display 23 may be covered by the side surface 230 (e.g., the side plate 24) of the housing. According to the embodiment, at least a partial area of the display 23 may be transparent.

According to various embodiments, a hardware component 25 may be located between the display 23 and the rear plate 26. According to an embodiment, the hardware component 25 includes at least one of a printed circuit board, a processor (e.g., the processor 120 of FIG. 1), an audio output module (e.g., the audio output module 155 of FIG. 1), and an audio module (e.g., the audio module 170 of FIG. 1), a sensor module (e.g., the sensor module 176 of FIG. 1), a connection terminal (e.g., the connection terminal 178 of FIG. 1), a haptic module (e.g., the haptic module 179 of FIG. 1), a camera module (e.g., the camera module 180 of FIG. 1), a power management module (e.g., the power management module 188 of FIG. 1), or a battery (e.g., the battery 189 of FIG. 1). **In** this regard, a support member (e.g., bracket and/or a flange) configured to fix the above-described hardware 25 may be included in the electronic device 201. For example, the support member may be formed of a metal (e.g., magnesium or the like) material or a plastic material. Furthermore, the support member may be a component that is integrated with the side surface 230 (e.g., the side plate 24) of the electronic device 201 or may be a component that is independent from the side surface 230.

According to various embodiments, the rear plate 26 may be an injection plastic material or a metal material. For design effects, a glass layer that surrounds the rear plate 26 may be provided as a component of the electronic device 201. **In** various embodiments, the rear plate 26 may be interpreted as the rear surface 220 of the housing 200.

Referring to FIGS. 2C and 2D, an electronic device 250 (e.g., the electronic device 101 of FIG. 1) according to various embodiments may be implemented to have a folded state and an unfolded state. According to an embodiment, the electronic device 250 may include a housing 251 and a display 252. This is to describe the exterior of the electronic device 250 according to various embodiments, and the electronic device 250 may further include other components in addition to the components described above.

According to various embodiments, the housing 251 may accommodate various components and may define the exterior of the electronic device 250, as described above. According to an embodiment, the housing 251 may include a first housing 251-1, in which at least a portion 252-1 of the display 252 is accommodated, and a second housing 251-2, in which at least another portion 252-2 of the display 252 is accommodated. For example, at least a portion of the first housing 251-1 and the second housing 251-2 may be formed of a metal material, or at least a portion thereof may be formed of a non-metal material.

According to various embodiments, at least a portion of the display 252 may be flexible. The display 252 may include a first area 252-1 (e.g., an upper area) that is placed on the first housing 251-1, and a second area 252-2 (e.g., a lower area) that is placed on the second housing 251-2, and a third area 252-3 (e.g., a central area) that is adjacent to the first housing 251-1 and the second housing 251-2. According to an embodiment, the entire display 252 may be flexible. Alternatively, at least a portion of the third area 252-3 of the display 252 may be provided to be flexible.

According to various embodiments, the electronic device 250 may include at least one hinge structure that connects the first housing 251-1 and the second housing 251-2. According to an embodiment, the first housing 251-1 and the second housing 251-2 may be configured to be rotated in opposite directions about a rotation axis of the hinge structure. For example, through rotation of the first housing 251-1 and the second housing 251-2, the electronic device 250 may be maintained in the folded state and the unfolded state.

Additionally or alternatively, the electronic device 250 may further include a first cover 253-1 that covers a rear surface of the first housing 251-1 and a second cover 253-2 that covering a rear surface of a second housing 521-2. Alternatively, a separate auxiliary display 254 may be further placed on the rear surface of the first housing 251-1.

According to various embodiments, the electronic device 250 has a first space that is defined by the first housing 251-1 and a second space that is defined by the second housing 521-2, as illustrated in FIG. 2D. According to an embodiment, various components of the electronic device 250 may be accommodated in the first space and the second space. For example, a main printed circuit board 261, a camera 263, a speaker 264, and a first battery 265 may be accommodated in the first space. Furthermore, a sub printed circuit board 262 and a second battery 266 may be accommodated in the second space. However, this is only an example, and the various embodiments are not limited thereto. For example, other components (e.g., a magnetic body or a metal flange member) in addition to the components described above may be accommodated in the first space and the second space.

A description of the electronic device 201 below may be applied equally or similarly to the electronic device 250 illustrated in FIGS. 2C and 2D.

As described above, at least a portion (e.g., a side plate 26) of the housing 200 (and/or the housing 251) may include a conductive area 2310 and a non-conductive area 2320 of dissimilar materials formed through insert molding. When an impact is applied to the housing 200 formed of the dissimilar materials, the conductive area 2310 and the non-conductive area 2320 are separated by the impact.

**In** this regard, the electronic device 201 (and/or the electronic device 250) according to various embodiments may include a reinforced structure in a part of the housing 200 to strengthen joining between dissimilar materials.

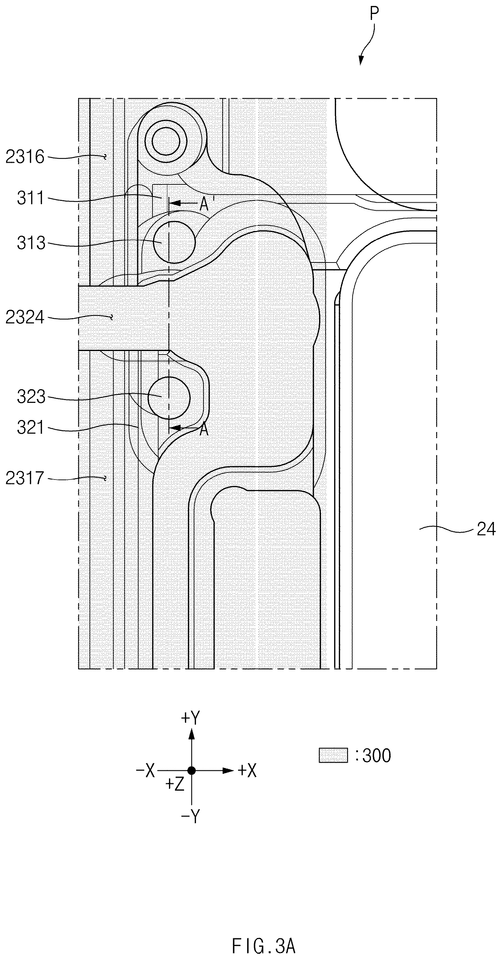

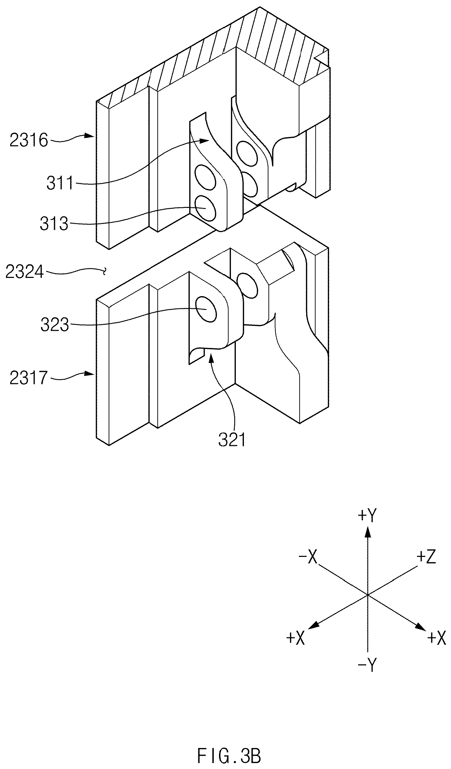

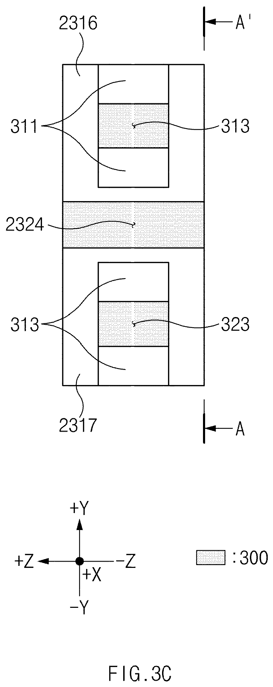

FIG. 3a is a view illustrating an interior of an electronic device including a reinforced structure. FIG. 3B is a view illustrating the reinforced structure, and FIG. 3C is a cross-sectional view, taken along line A-A' of FIG. 3A.

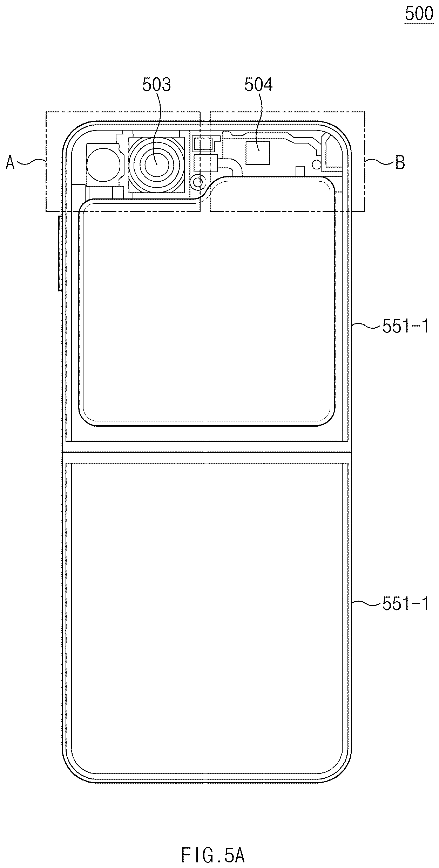

Referring to FIGS. 3A to 3C, a side plate 24, on which a non-conductive material 300 is insert-molded, may be placed in the interior of the electronic device 201 (and/or the electronic device 250) according to various embodiments. At least a portion of the side plate 24 may define a conductive area 2310 and at least a portion of the non-conductive material 300 may define a non-conductive area 2320. For example, the interior of the electronic device 201 illustrated in FIG. 3A may correspond to some areas (e.g., area "P" of FIG. 2A, area "A" of FIG. 5A, area "B" of FIG. 5A) including the conductive area 2310 and the non-conductive area 2320 of the side surface 230 of the housing 200 (and/or the housing 251).

According to various embodiments, a reinforced structure that protrudes toward the interior of the electronic device 201 and includes at least one aperture for injection may be formed in the conductive area 2310. For example, a plurality of reinforced structures may be formed in at least one conductive area (e.g., any one of the first to ninth conductive areas 2311 to 2319). For example, when the plurality of reinforced structures are formed in at least one conductive area, each of the reinforced structures may be continuously placed at regular intervals along a length of the conductive area (e.g., in the +Y-axis or -Y-axis direction).

According to an embodiment, as described above with reference to FIG. 2A, the housing 200 (e.g., the third side surface 230c of the side plate 24) corresponding to area "P" may include a sixth conductive area 2316 and a seventh conductive area 2317, and a fourth non-conductive area 2324 that is placed therebetween. For example, as illustrated in FIGS. 3A to 3C, a first reinforced structure 311 including at least one first aperture 313 for injection is formed in the sixth conductive area 2316, and a second reinforced structure 321 including at least one second aperture 323 for injection may be formed in the seventh conductive area 2317. **In** other words, the first reinforced structure 311 may include at least one first protruding part that protrudes toward the interior of the electronic device 201, and the at least one first aperture 313 for injection may be formed in at least one first protruding part of the first reinforced structure 311. Furthermore, the second reinforced structure 321 may include at least one second protruding part that protrudes toward the interior of the electronic device 201, and at least one second aperture 323 for injection may be formed in at least one second protruding part of the second reinforced structure 321.

According to the embodiment, at least one of the first reinforced structure 311 and the second reinforced structure 321 may be formed adjacent to the fourth non-conductive area 2324. Furthermore, at least one aperture 313 and 323 for injection may be formed to penetrate the reinforced structure 311 and 321, and may be formed in a form that does not penetrate the reinforced structure 311 and 321.

Accordingly, when the non-conductive material 300 is insert-molded into the side plate 24 of the conductive material, as illustrated in FIG. 3C, the non-conductive material 300 may be insert-molded into at least one first aperture 313 for injection and at least one second aperture 323 for injection so that the joining forces between the sixth conductive area 2316, the seventh conductive area 2317, and the fourth non-conductive area 2324 may be strengthened.

As described above, the electronic device 201 according to various embodiments may include the reinforced structures 311 and 321 to strengthen the joining force of the conductive area 2310 and the non-conductive area 2320 of the housing 200. Furthermore, as the size or number of reinforced structures 311 and 321 provided in the electronic device 201 increases, the joining force of the conductive area 2310 and the non-conductive area 2320 may also increase.

However, when the reinforced structures 311 and 321 are formed in the conductive area 2310 used as an antenna, a spacing distance between the components (e.g., a conductive structure including a metal part, such as a speaker, a magnet, a display, a screw, a flange member, or a metal mechanism) in the interior of the electronic device 201 and the reinforced structures 311 and 321 are not secured at a specific level or higher due to the protruding reinforced structures 311 and 321 whereby the performance of the antenna may deteriorate.

In this regard, in the various embodiments below, the arrangement of the reinforced structures 311 and 321 may be varied to secure the spacing distance between the reinforced structures 311 and 321 and the component in the interior of the electronic device 201 at a certain level whereby the joining force of the conductive area 2310 and the non-conductive area 2320 may be strengthened and the performance of the antenna may be improved.

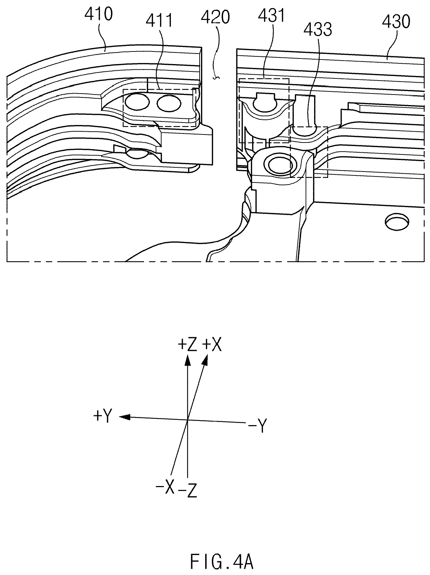

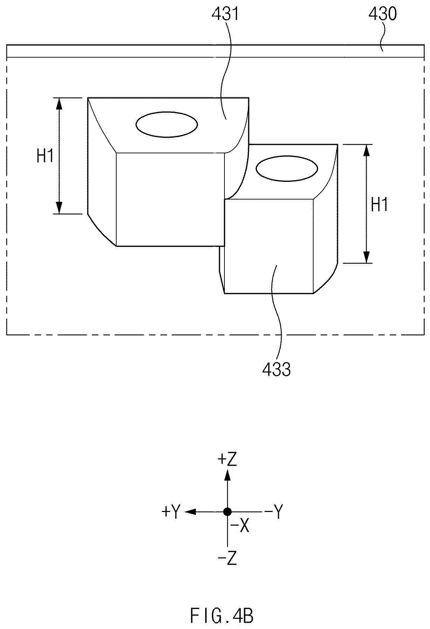

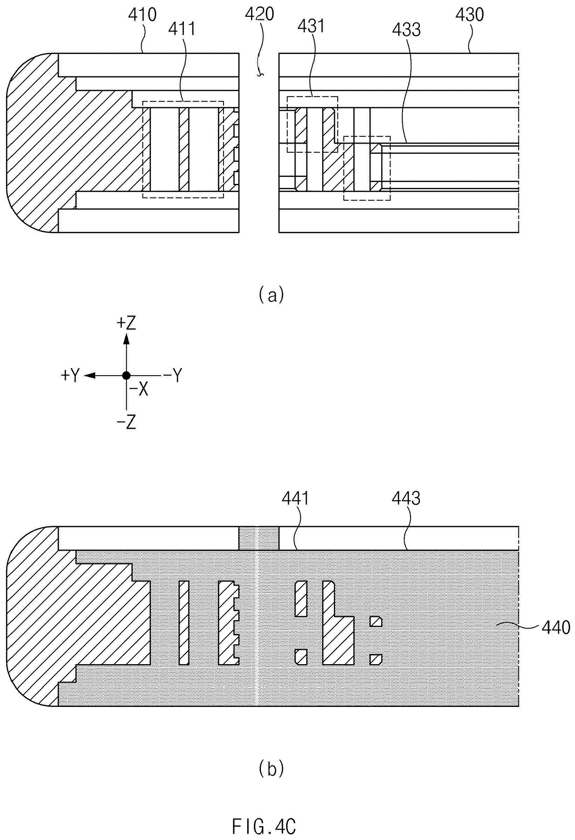

FIG. 4A is a view illustrating a projection of the interior of an electronic device including a reinforced structure according to various embodiments. FIG. 4B is a view illustrating the reinforced structure, and FIG. 4C is a view illustrating the housing, in which the non-conductive material is insert-molded according to various embodiments.

Referring to FIGS. 4A and 4B, the electronic device 201 according to various embodiments have a different arrangement of the reinforced structures 411, 431, and 433, and thus, the distance between the reinforced structures 411, 431, and 433, and the component (e.g., the conductive structure) of the interior of the electronic device 201 may be secured at a specific level or higher.

According to an embodiment, the electronic device 201 may include the plurality of reinforced structures 411, 431, and 433, and a placement height of at least one of the reinforced structures 411, 431, and 433 may be different from the placement heights of other reinforced structures. For example, the placement height of at least one of the first reinforced structure 411 formed in the first conductive area 410, the second reinforced structure 431 formed in the second conductive area 430, or a third reinforced structure 433 formed in the second conductive area 430 may be different. For example, the placement height of a reinforced structure 433 of one of the plurality of reinforced structures 431 and 433 formed in one conductive area 430 may be varied.

For example, as illustrated in FIG. 4B, the placement heights of the second reinforced structure 431 having a first height H1 and the third reinforced structure 433 having a first height H1 are made different, one surface (e.g., an upper surface that faces the +z-axis direction or a lower surface that faces the -z-axis direction) of the second reinforced structure 431 and one surface of the third reinforced structure 433 may be placed at different heights or on different planes (e.g., the X-Y plane). In this regard, the placement heights of the reinforced structure 411, 431, and 433 and the spacing distances between components in the electronic device 201 will be described in detail with reference to FIGS. 5A to 5F below.

As described above, when the non-conductive material 440 is insert-molded into the side plate 430 of the conductive material, the non-conductive material 300 is filled into at least one aperture for injection formed in the first reinforced structure 411, the second reinforced structure 431, and the third reinforced structure 433, a joining force of the first conductive area 410 and the second conductive area 430, and the non-conductive area 420 placed therebetween may be strengthened.

According to various embodiments, the placement heights of the reinforced structures 411, 431, and 433 does not influence an injection boundary of the non-conductive material 300. In other words, as illustrated in (a) of FIG. 4C, a second reinforced structure 431 is formed in a part of the second conductive area 430 at the same placement height as the placement height of the first reinforced structure 411 formed in the first conductive area 410, a non-conductive material 440 (e.g., the non-conductive material 300) may be insert-molded into the side plate 430, in which the third reinforced structure 433 is formed in another part of the second conductive area 430 at a placement height that is different from those of the first reinforced structure 411 and the second reinforced structure 431 and accordingly the antenna performance may be prevented from deteriorating.

In this case, as illustrated in (b) of FIG. 4C, an injection boundary 441 corresponding to the second reinforced structure 431 and an injection boundary 443 corresponding to the third reinforced structure 433 may be the same. Accordingly, even when the placement heights of the reinforced structures 411, 431, and 433 are different, additional processing (e.g., attachment of waterproof tape, and the like) on the injection boundary may be possible.

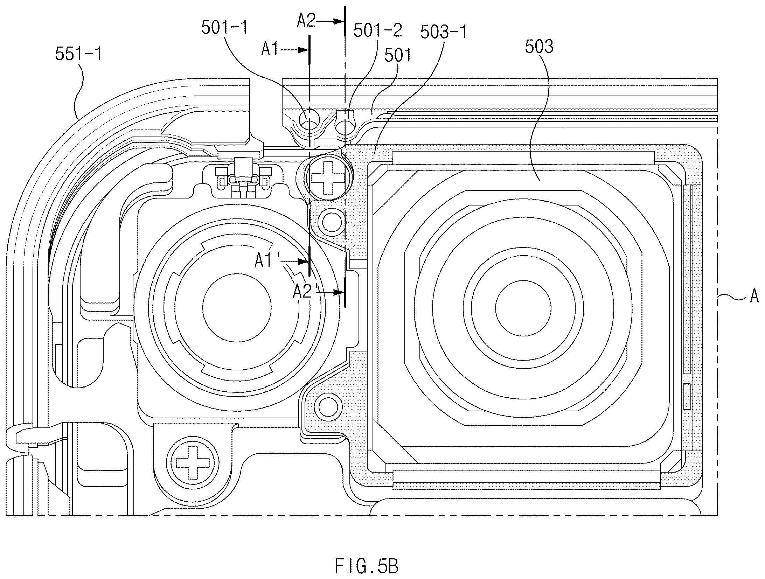

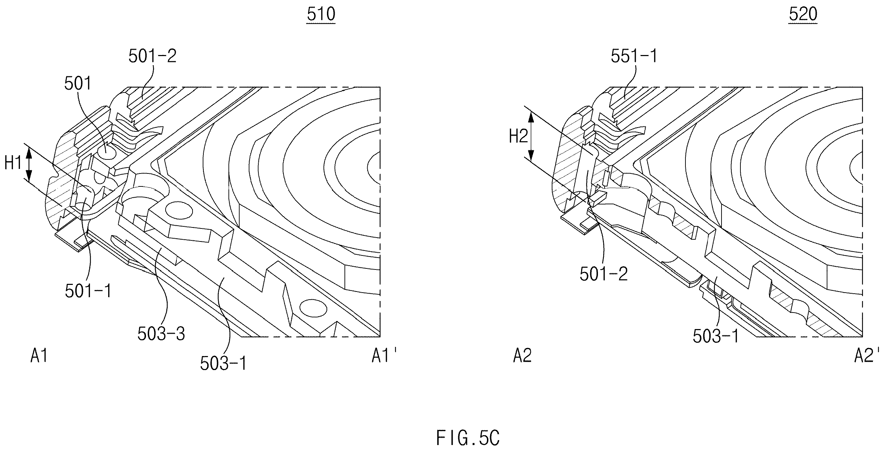

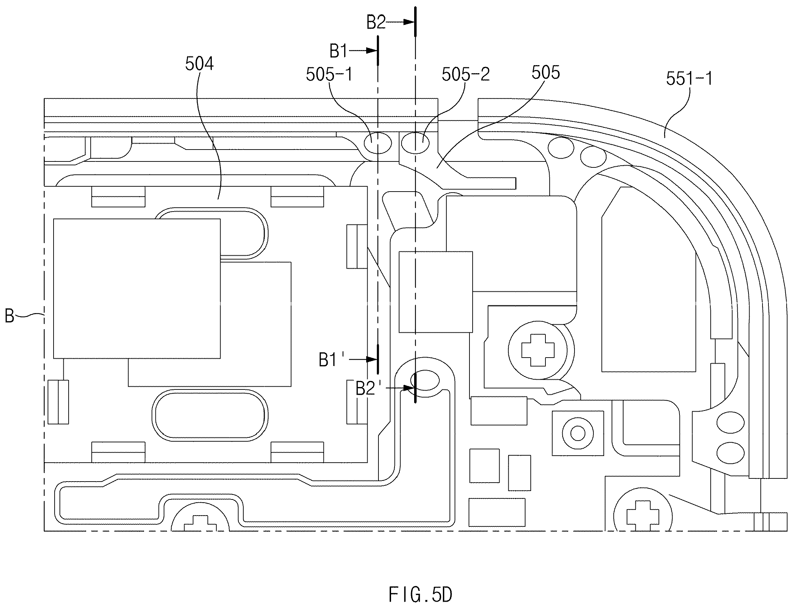

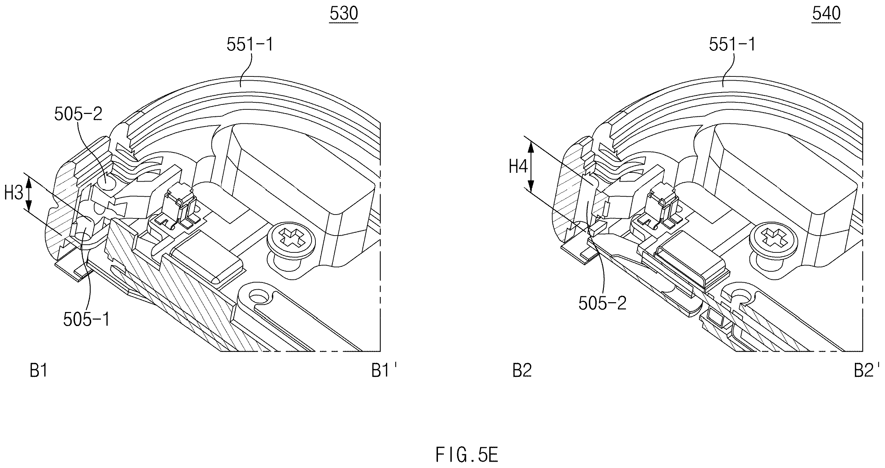

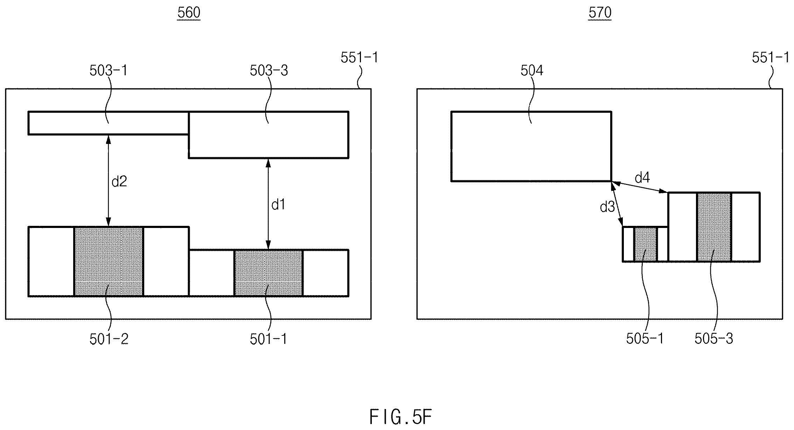

FIG. 5A is a view illustrating internal components of the electronic device. Furthermore, FIGS. 5B and 5C are views illustrating an arrangement of the reinforced structure according to various embodiments, FIGS. 5D and 5E are other views illustrating an arrangement of the reinforced structure according to various embodiments and a spacing distance between the components in the interior of the electronic device, and FIG. 5F is a view illustrating the spacing distance between the reinforced structure and the internal components of the electronic device according to various embodiments.

Referring to FIG. 5A, various components may be provided in the interior of an electronic device 500 (e.g., the electronic device 201 and the electronic device 250) according to various embodiments. According to an embodiment, various components may be provided in a space defined by the housing (e.g., a first housing 551-1 and a second housing 551-3) of the electronic device 500. For example, a camera 503 and a speaker 504 may be provided in the interior of the electronic device 500. However, this is only an example, and the various embodiments are not limited thereto. For example, various components in addition to the components described above may be included in the electronic device 500.

According to the embodiment, as illustrated in FIG. 5B, a first reinforced structure 501 that protrudes toward the interior of the electronic device 500 and includes a first aperture 501-1 for injection and a second aperture 501-2 for injection may be formed in the housing (e.g., the first housing 551-1). Furthermore, the electronic device 500 may include a support member 503-1 (e.g., a flange) that is formed of metal, on which the camera 503 is mounted. According to an embodiment, the support member 503-1 may be configured to fix the camera 503.

As described above, the spacing distance between at least a portion of the housing (e.g., the first housing 551-1) used as an antenna, and the support member 503-1 needs to be secured at a specific level or higher.

As illustrated in FIG. 5C, at least a portion of one surface (e.g., a rear surface) of the support member 503-1 may include a step layer 503-3 having a specified thickness (e.g., height). The distance between a portion of the support member 503-1, at which the step layer 503-3 is formed, and the first reinforced structure 501 may be different from a distance between another portion of the support member 503-1, at which the step layer 503-3 is not formed, and the first reinforced structure 501. For example, when a height of an upper end of the first reinforced structure 501 is placed in a position that is lower than a height of an upper end of the support member 503-1, a portion of the support member 503-1, at which the step layer 503-3 is formed may be more adjacent to the first reinforced structure 501 than the other portions. In other words, the distance between the first reinforced structure 501 and the support member 503-1 may not be secured at a specific level or higher due to a thickness of the step layer 503-3.

In this regard, the arrangement of the first reinforced structure 501 according to various embodiments may be determined by considering the spacing distance from the support member 503-1. According to an embodiment, the height of the first aperture 501-1 for injection that is adjacent to the portion of the support member 503-1, at which the step layer 503-3 is formed, and the height of the second aperture 501-2 for injection that is adjacent to the other portion, at which the step layer 503-3 is not formed, may be made different.

According to an embodiment, as in 510 of FIG. 5C, the first aperture 501-1 for injection that is adjacent to the portion of the support member 503-1, at which the step layer 503-3 is formed, may have a first height H1. The first height H1 of this first aperture 501-1 for injection may be lower than a second height H2 of the second aperture 501-2 for injection that is adjacent to the other portion of the support member 503-1, at which the step layer 503-3 is not formed, which is illustrated in 520 of FIG. 5C.

By the embodiment, as in 560 in FIG. 5F, similarly to the spacing distance d2 between the other portion of the support member 503-1, at which the step layer 503-3 is not formed, and the second aperture 501-2 for injection, the spacing distance d1 between the portion of the support member 503-1, at which the step layer 503-3 is formed, and the first aperture 501-1 for injection may also be secured at a specific level or higher, and accordingly, an antenna performance of a specific level or higher may be expected.

In an embodiment, the spacing distance d1 between the first reinforced structure 501 and the camera 503 may be related to a wavelength (λ) of radio waves that are transmitted and received through the antenna. For example, when the first housing 551-1 is used as an antenna of a 2 GHz frequency band, the wavelength of the radio waves transmitted and received through the antenna may be approximately 3 cm. In this situation, the performance of the antenna may be prevented from deteriorating by ensuring that the first reinforced structure 501 and the camera 503 are spaced apart from each other by more than at least the wavelength (λ) of the radio waves.

According to the embodiment, as illustrated in FIG. 5D, a second reinforced structure 505 that protrudes toward the interior of the electronic device 500 and includes a third aperture 505-1 for injection and a fourth aperture 505-2 for injection. For example, the second reinforced structure 505 may be formed adjacent to the speaker 504 provided in the interior of the electronic device 500.

As described above, the spacing distance between at least a portion of the housing (e.g., the first housing 551-1) used as an antenna and the speaker 504 needs to be secured at a specific level or higher.

In this regard, the arrangement of the second reinforced structure 505 according to various embodiments may be determined by considering the spacing distance from the speaker 504. According to an embodiment, the height of the third aperture 505-1 for injection that is relatively adjacent to the speaker 504 and the height of the fourth aperture 505-2 for injection that is relatively spaced apart from the speaker 504 may be made different.

According to an embodiment, as illustrated in 530 of FIG. 5E, the third aperture 505-1 for injection that is relatively adjacent to the speaker 504 may be formed to have a third height H3. The third height H3 of the third aperture 505-1 for injection may be lower than a fourth height H4 of the fourth aperture 505-2 for injection that is relatively spaced apart from the speaker 504, which is illustrated in 540 in FIG. 5E.

According to this embodiment, as in 570 of FIG. 5F, similarly to a spacing distance d4 between the speaker 504 and the fourth aperture 505-2 for injection, a spacing distance d3 between the speaker 504 and the third aperture 505-1 for injection may be secured at a specific level or higher.

As described above, in various embodiments, the arrangement of the reinforced structure (e.g., the first reinforced structure 501 and the second reinforced structure 505) may be made different to secure the spacing distance between the reinforced structure and the internal components of the electronic device 500 at a constant level, and through this, the joining force of the conductive area 2310 and the non-conductive area 2320 may be strengthened and the antenna performance may be prevented from deteriorating.

Furthermore, not only the placement height of the reinforced structure, but also the shape (e.g., a width, a depth, a height, and the like) of the reinforced structure may influence the performance of the antenna. For example, as at least one of the width, depth, or height of the reinforced structure increases, the performance of the antenna may deteriorate.

In this regard, additionally or selectively, in various embodiments, the joining force of the conductive area 2310 and the non-conductive area 2320 may be strengthened and the performance of the antenna may be improved by varying the shape of the reinforced structure.

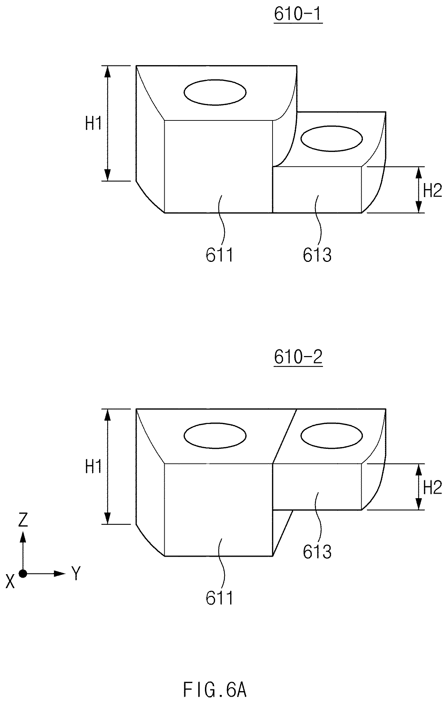

FIGS. 6A to 6F are views illustrating the shape of the reinforced structure according to various embodiments.

Referring to FIGS. 6A to 6F, in various embodiments, the joining force of a conductive area 3210 and the non-conductive area 2320 may be strengthened and the performance of the antenna may be improved by adjusting (e.g., decreasing) a ratio occupied by the conductive material of the reinforced structure (e.g., the reinforced structures 411, 431, and 433 of FIG. 4).

As a part of a plan to reduce the ratio of conductive material of the reinforced structure, the height of at least one reinforced structure (e.g., the protruding part) is made different from the heights of the other reinforced structures. For example, as illustrated in FIG. 6A, unlike a first reinforced structure 611 having the first height H1, a second reinforced structure 613 has the second height H2 that is smaller than the first height H1.

In this regard, based on the arrangement of the components in the interior of the electronic device 201, the upper surface (e.g., a surface that faces the +z-axis direction) or the lower surface (e.g., a surface that faces the -z-axis direction) of the first reinforced structure 311 may be placed on the same plane as the upper or lower surface of the second reinforced structure 613.

For example, when the height of the component in the interior of the electronic device 201 is higher than or similar to the height of the upper surface of the second reinforced structure 613, as illustrated in 610-1 of FIG. 6A, the lower surface of the first reinforced structure 611 and the lower surface of the second reinforced structure 613 may be placed on the same plane (e.g., the X-Y plane) and the upper surface of the first reinforced structure 611 may be placed on a plane that is different from the upper surface of the second reinforced structure 613 whereby the first height H1 of the first reinforced structure 611 and the height H2 of the second reinforced structure 613 may be made different.

As another example, when the height of the component in the interior of the electronic device 201 is lower than or similar to the height of the upper surface of the second reinforced structure 613, as illustrated in 610-2 of FIG. 6A, the upper surface of the first reinforced structure 611 and the upper surface of the second reinforced structure 613 may be placed on the same plane and the lower surface of the first reinforced structure 611 may be placed on a plane that is different from the lower surface of the second reinforced structure 613 whereby the first height H1 of the first reinforced structure 611 and the second height H2 of the second reinforced structure 613 may be made different.

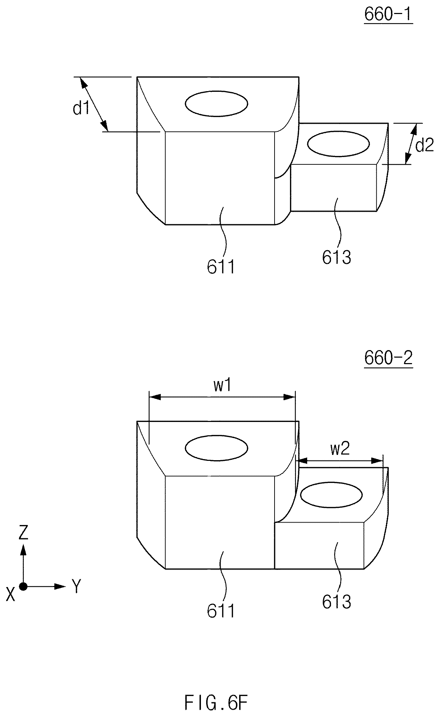

However, this is only an example, and the various embodiments are not limited thereto. For example, as in 660-1 of FIG. 6F, a depth d2 of the second reinforced structure 613 may be made different from a depth d1 of the first reinforced structure 611, or as in 660-2 of FIG. 6F, a width w2 of the second reinforced structure 613 may be made different from a width w1 of the first reinforced structure 611. Furthermore, according to the embodiment, at least two of the height, the depth, or the width of the second reinforced structure 613 may be made different from those of the first reinforced structure 611.

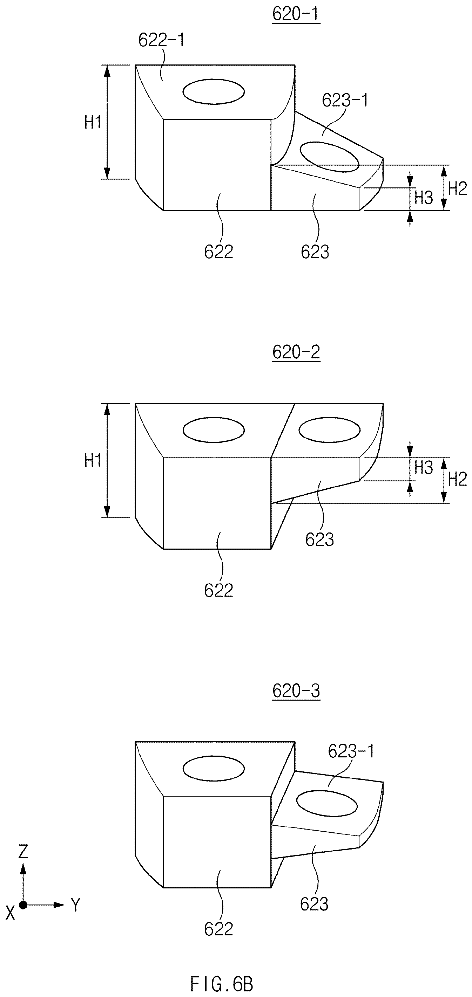

According to various embodiments, as a part to reduce the ratio of the conductive material of the reinforced structure, at least one reinforced structure may be inclined differently from other reinforced structures. For example, as illustrated in FIG. 6B, unlike a first reinforced structure 622 including a surface 622-1 that protrudes parallel to the interior of the electronic device 201, a second reinforced structure 623 may include an inclined surface 623-1 that protrudes toward the interior of the electronic device 201 and is inclined at a specific angle along the widthwise direction and/or the depth direction thereof. For example, one end of the inclined surface 623-1 of the second reinforced structure 623 may be formed to have the second height H2 that is lower than the first height H1, and an opposite end thereof may be formed to have a third height H3 that is lower than the second height H2.

In this regard, a position, in which the inclined surface 623-1 is formed, may vary based on the arrangement of the components in the interior of the electronic device 201. For example, as illustrated in 620-1 of FIG. 6B, an inclined surface may be formed on the upper surface of the second reinforced structure 623, and as illustrated in 620-2 of FIG. 6B, an inclined surface 623-1 is formed on the lower surface of at least one reinforced structure 623. Furthermore, as illustrated in 620-3 of FIG. 6B, the inclined surface 623-1 may be formed on both of the upper and lower surfaces of the second reinforced structure 623.

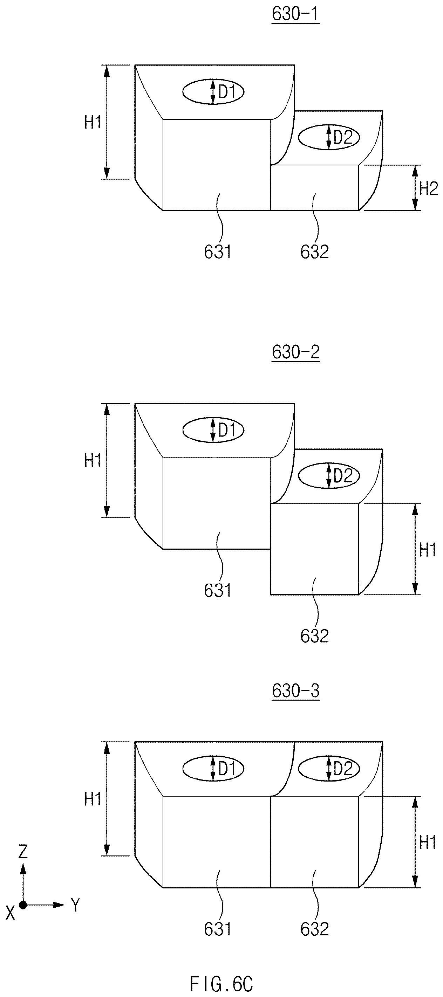

According to various embodiments, as a part to reduce the ratio of the conductive material of the reinforced structure, a diameter of the aperture for injection formed in at least one reinforced structure may be made different from those of other reinforced structures. For example, as illustrated in FIG. 6C, unlike a first reinforced structure 631, in which an aperture for injection of a first diameter D1 is formed, a second reinforced structure 632 has an aperture for injection of a second diameter D2 that is larger than the first diameter D1. As illustrated, the ratio of the conductive material of the second reinforced structure 632, in which the aperture for injection of the second diameter D2 is formed, may be relatively reduced compared to the ratio of the conductive material of the first reinforced structure 631, in which the aperture for injection of the first diameter D1 is formed.

According to an embodiment, as illustrated in 630-1 of FIG. 6C, an aperture for injection of a first diameter D1 may be formed in the first reinforced structure 631 having a first height H1, and an aperture for injection of a second diameter D2 that is larger than the first diameter D1 may be formed in the second reinforced structure 632 having a second height H2 that is lower than the first height H1.

According to an embodiment, as in 630-2 of FIG. 6C, an aperture for injection of a first diameter D1 may be formed in the first reinforced structure 631 having the first height H1 formed at the first placement height, and an aperture for injection of the second diameter D2 that is larger than the first diameter D1 may be formed in the second reinforced structure 632 having the first height H1 formed at a second placement height lower than the first placement height.

According to an embodiment, as in 630-3 of FIG. 6C, the aperture for injection of the second diameter D2 be formed in the second reinforced structure 632 that has the same height as that of the first reinforced structure 631 and is formed at the same placement height.

The structure, in which the aperture for injection of the above-described second diameter D2 is formed in the second reinforced structure 632, is an embodiment, and various embodiments are not limited thereto. For example, the aperture for injection of the second diameter D2 may be formed in the first reinforced structure 631, or may be formed in both of the first reinforced structure 631 and the second reinforced structure 632.

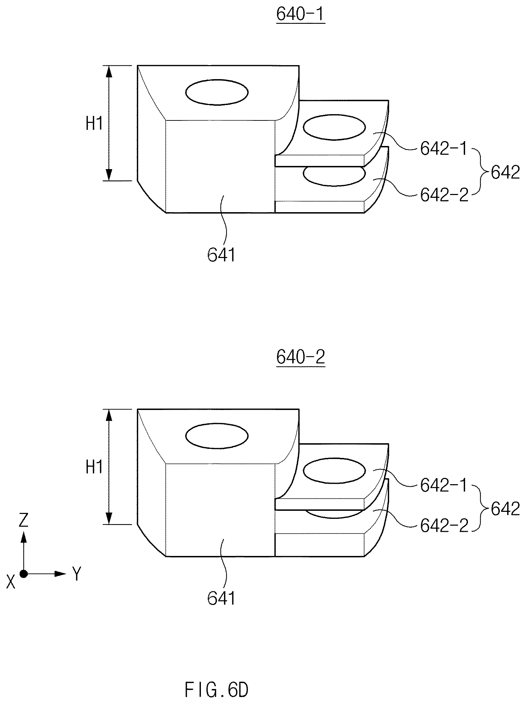

According to various embodiments, as a part to reduce the ratio of the conductive material of the reinforced structure, the number of the at least one reinforced structure may be made different from the number of the other reinforced structures. For example, as in 640-1 of FIG. 6D, unlike the one first reinforced structure 641, a second reinforced structure 642 may include a plurality of second reinforced structures 642-1 and 642-2.

As illustrated, the heights of the plurality of second reinforced structures 642-1 and 642-2 may be smaller than the first height H1 of the first reinforced structure 641, and, even when the heights of the second reinforced structures 642-1 and 642-2 is added, it may be made smaller than the first height H1 of the first reinforced structure 641 whereby the ratio of the conductive material of the second reinforced structures 642-1 and 642-2 may be decreased.

In this regard, smaller heights of the second reinforced structures 642-1 and 642-2 may help maintain antenna performance, but may weaken the joining force of a non-conductive areas 2320.

Accordingly, additionally or selectively, as in 640-2 of FIG. 6D, the heights of the plurality of second reinforced structures 642-1 and 642-2 may be made different to supplement strengthening of the joining force of the conductive area 2310 and the non-conductive area 2320. For example, the height of any one of a plurality of second reinforced structures 641-1 and 642-2 may be made larger than the height of the other second reinforced structure 642-1 to supplement the joining force.

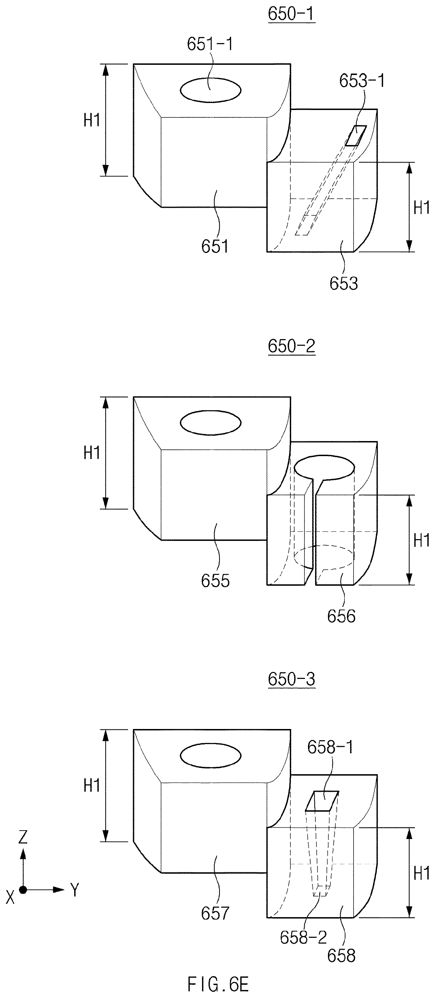

According to various embodiments, as a part to reduce the ratio of the conductive material of the reinforced structure, the form of the aperture for injection for at least one reinforced structure may be made different. For example, as in 650-1 of FIG. 6E, unlike a first reinforced structure 651, in which a cylindrical insert-molded opening 651-1 is formed, the insert-molded opening 653-1 of a second reinforced structure 653 may be formed in a box shape. Furthermore, according to the embodiment, to further secure an area of an insert-molded opening 653-1 of the second reinforced structure 653, the insert-molded opening 653-1 of the second reinforced structure 653 may be formed to be inclined diagonally.

As another example, as in 650-2 of FIG. 6E, unlike a first reinforced structure 655, in which the outer peripheral surface is integrally formed, a second reinforced structure 656 may be formed in a pincer shape, in which an opening is formed at least a portion of an outer peripheral surface thereof. According to the embodiment, the shape of the second reinforced structure 656 may be determined by the spacing distance from the components within the electronic device. For example, when the spacing distance between the second reinforced structure 656 and the components is the first distance or more, the outer peripheral surface of the second reinforced structure 656 may be integrally formed similarly to or identically to the first reinforced structure 655. Furthermore, when the spacing distance between the second reinforced structure 656 and the components is less than the first distance, an opening may be formed at least a portion of the outer peripheral surface of the second reinforced structure 656, unlike the first reinforced structure 655.

As another example, as in 650-3 of FIG. 6E, unlike a first reinforced structure 657, in which the upper surface and the lower surface of the insert-molded opening have the same form, a second reinforced structure 658 may include an aperture for injection, in which the form (e.g., the size, the shape, and the like) of an upper surface 658-1 and the form of a lower surface 658-2 are different.

The form of the reinforced structure described through FIGS. 6A to 6F is an example for strengthening the joining force of the non-conductive areas 2320 and improving antenna performance, and various embodiments are not limited thereto. For example, the strengthening of the joining force and the improvement of the antenna performance may be achieved by a combination of at least two of the embodiments described with reference to FIGS. 6A to 6F.

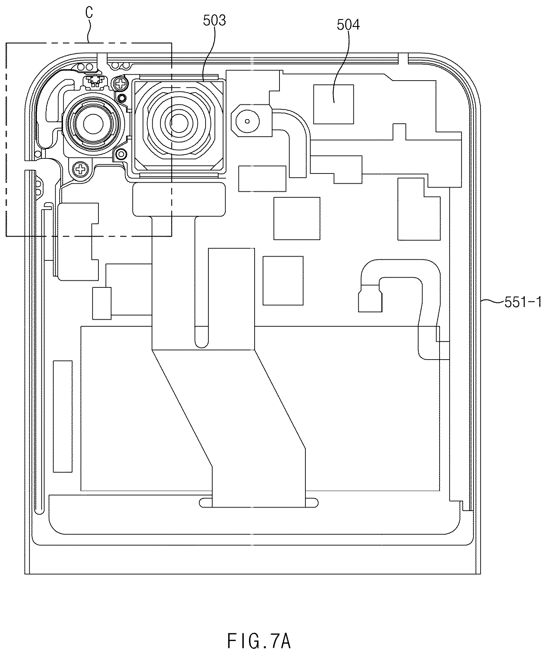

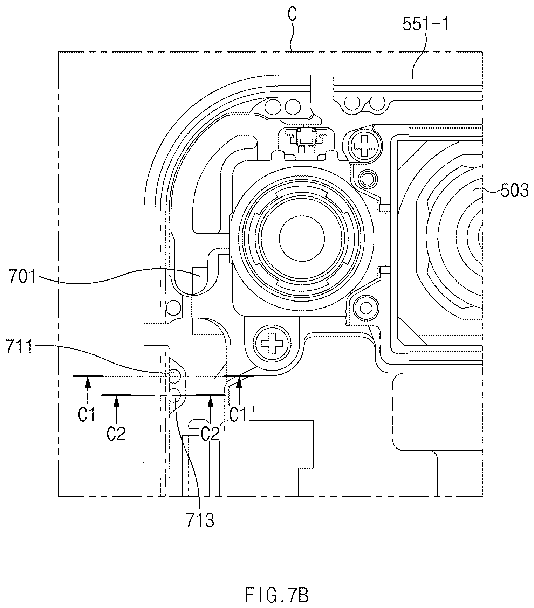

FIGS. 7A to 7D illustrate electronic devices, to which various embodiments are applied.

Referring to FIGS. 7A to 7D, various components may be provided in the interior of the electronic device 500 (e.g., the electronic device 250 of FIG. 2A) according to various embodiments. According to an embodiment, various components may be provided in the space defined by the housing (e.g., the first housing 551-1 and the second housing 551-3) of the electronic device 500. For example, a camera 503, a speaker 504, and a magnet 701 may be provided in the interior of the electronic device 500. Furthermore, the conductive area (e.g., first housing 551-1) of the electronic device 500, a reinforced structure 710 that is formed to extend toward the interior of an electronic device 700 and includes at least one aperture for injection (e.g., a fifth aperture 711 for injection and a sixth aperture 713 for injection) may be formed.

According to an embodiment, at least one magnet 701 may be configured to maintain the folded state of the first housing 551-1 and the second housing 551-3. However, the at least one magnet 701 may deteriorate antenna performance.

In this regard, the arrangement of the reinforced structure 710 according to various embodiments may be determined by considering a spacing distance from the magnet 701. According to an embodiment, the height of the fifth aperture 711 for injection that is relatively adjacent to the magnet 701 may be different from the height of the sixth aperture 713 for injection that is spaced apart from the magnet 701.

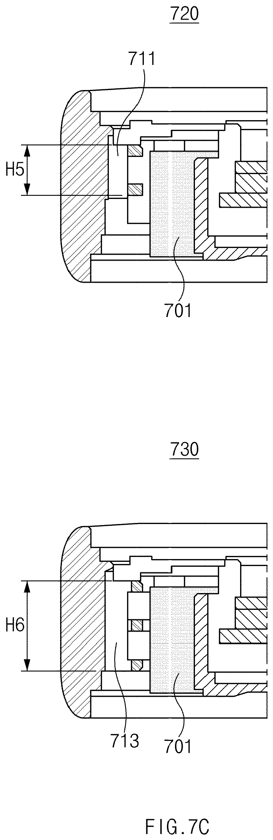

According to an embodiment, as in 720 of FIG. 7C, the fifth aperture 711 for injection that is relatively adjacent to the magnet 701 may be formed to have a fifth height H5. The fifth height H5 of the fifth aperture 711 for injection may be lower than the sixth height H6 of the sixth aperture 713 for injection illustrated in 730 in FIG. 7C, which is relatively spaced apart from the magnet 710.

In this way, as the area of the fifth aperture 711 for injection decreases by the height difference from the sixth aperture 713 for injection, degradation of the antenna performance may be prevented.

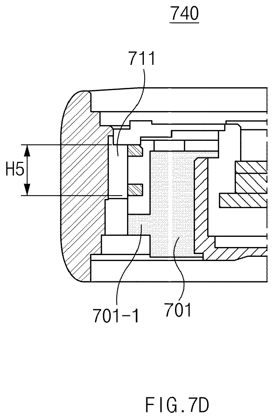

Additionally or selectively, the performance of the magnet 701 may be improved by increasing the area of the magnet 701 based on a decrease in the area of the fifth aperture 711 for injection. For example, as in 740 of FIG. 7D, an expansion magnet 701-1 that is expanded by at least a specific distance toward the reinforced structure 710 may be additionally placed adjacent to the fifth aperture 711 for injection.

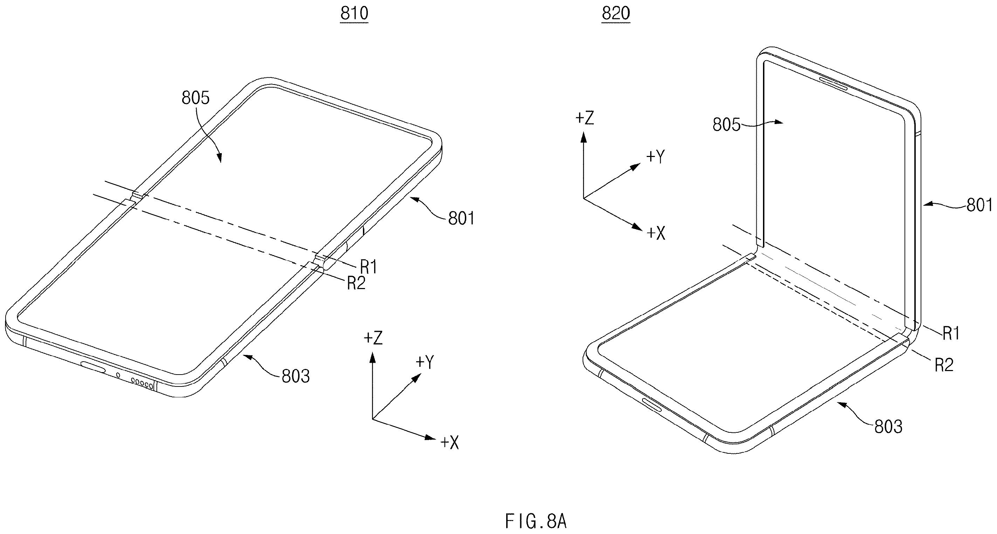

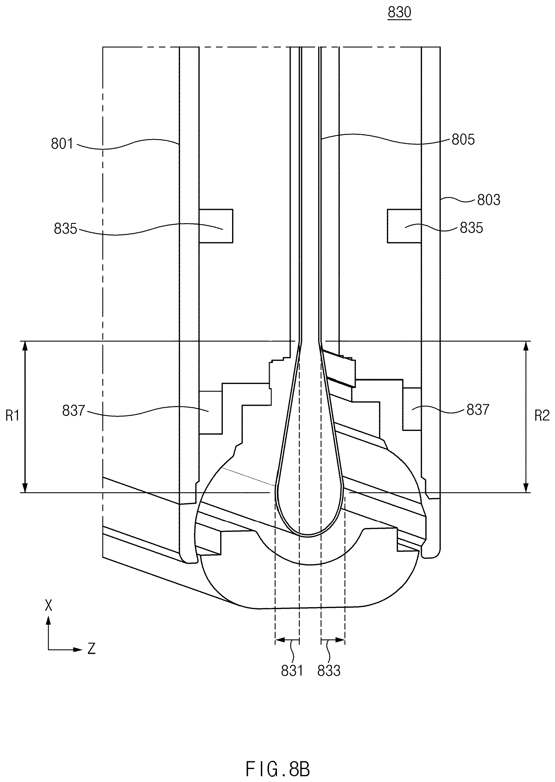

FIGS. 8A and 8B illustrate other electronic devices, to which various embodiments are applied.

Referring to FIGS. 8A and 8B, an electronic device (e.g., the electronic device 201 of FIG. 2A) according to various embodiments may include a first housing 801, a second housing 803, and a display 805.

According to an embodiment, as illustrated at 810 in FIG. 8A, the electronic device may support a state, in which the display 805 is unfolded, and a state, in which the display 805 is folded. For example, the first housing 801 and the second housing 803 may be configured to be rotated in opposite directions about rotation axes R1 and R2 thereof.

According to an embodiment, when the electronic device is in a fully unfolded state and in an intermediate folded state, the display 805 may define a substantially flat surface, and when the electronic device is in a fully folded state, at least a portion of the display 805 may define a curved surface having a specific curvature.

For example, as illustrated in FIG. 8B, curved surfaces 831 and 833 may be formed in a partial area of the display 805 like a dumbbell shape or a water drop shape around the rotation axis R1 of the first housing 801 and the rotation axis R2 of the second housing 803.

In this regard, the curved surfaces 831 and 833 formed on the display 805 may become adjacent to the reinforced structures formed on the first housing 801 and the second housing 803 whereby the performance of the antenna may deteriorate.

According to various embodiments, the placement height of a reinforced structure 837 that is adjacent to the curved surfaces 831 and 833 formed in the display 805 and the placement height of a reinforced structure 835 that is adjacent to the plane formed in the display 805 may be made different whereby degradation of the antenna performance may be prevented.

## Claims

1. A housing(200) for an electronic device (201) comprising:
a front surface (210) of the electronic device, a rear surface (220) of the electronic device, and a side surface (230) surrounding a space between the front surface and the rear surface,
wherein the side surface comprises:
a first conductive area (2316) and a second conductive area (2317) formed with a conductive material;
a non-conductive area (2324) formed with a non-conductive material;
a first reinforcedstructure (311) formed at a part of the first conductive area (430) and comprising a first protrusion part protruding toward the space between the front surface (210) and the rear surface (220),
wherein the first protrusion part includes a first part (611) having a first height and a second part (613) having a second height different from the first height.

2. An electronic device (201) comprising:
a display (252); and
a housing (200) according to claim 1, in which the display (252) is placed, forming an exterior of the electronic device (201).

3. The electronic device (201) of claim 2**,**
wherein the first height and the second height are different when viewed in a first direction where the display (252) is facing or a second direction opposite to the first direction.

4. The electronic device (201) of claim 2,
wherein a first aperture for injection (313) and a second aperture for injection (323) are formed at the first protrusion part and the second protrusion part,
wherein the first aperture for injection (313) and the second aperture for injection (323) are penetrating the first protrusion part and the second protrusion part in the first direction where the display is facing or in the second direction opposite to the first direction, and
wherein the first aperture (313) and the second aperture for injection (323) are configured to be filled with the non-conductive material.

5. The electronic device (201) of claim 2**,** further comprising:
a conductive structure (701),
wherein the first part (611) of the first protrusion part and second part (613) of the first protrusion part are formed at a first placement height and a second placement height respectively such that the first part (611) of the first protrusion part and the second part (611) of the first protrusion part are spaced apart from the conductive structure at least by a distance.

6. The electronic device (201) of claim 5, wherein, when the conductive structure is more adjacent to the first part (611) of the first protrusion part than the second part (613) of the first protrusion part and when the conductive structure is placed at a position higher than the first placement height, the second part (613) of the first protrusion part is formed at a second placement position higher than the first placement height.

7. The electronic device (201) of claim 5**,** wherein, when the conductive structure is more adjacent to the first part (611) of the first protrusion part than the second part (613) of the first protrusion part and when the conductive structure is placed at a position lower than the first placement height, the second part (613) of the first protrusion part is formed at a second placement position lower than the first placement height.

8. The electronic device (201) of claim 2,
wherein at least one of the first part (611) of the first protrusion part and the second part (613) of the first protrusion part comprises an inclined surface,
wherein the inclined surface, when viewed in a first direction where the display is facing or in a second direction opposite to the first direction, is inclined by an angle with respect to a display surface of the display.

9. The electronic device (201) of claim 2**,** wherein the first part (611) of the first protrusion part and the second part (613) of the first protrusion part are different from in at least one of numbers, heights, widths, or depths.

10. The electronic device (201) of claim 4**,** wherein the first aperture for injection (313) and the second aperture for injection (323) are differently formed at the first part (611) of the first protrusion part and the second part (613) of the first protrusion part in at least one of numbers, sizes, or shapes.

11. The electronic device (201) of claim 2**,** wherein at least one of the first part (611) of the first protrusion part and the second part (613) of the first protrusion part comprises an outer peripheral surface where an opening is formed.

12. The electronic device (201) of claim 3**,** wherein the housing is formed by injecting the non-conductive material to a conductive plate with an insert molding, and
wherein, when viewed in the first direction, a height of an injection boundary corresponding to the first part (611) of the first protrusion part and a height of an injection boundary corresponding to the second part (613) of the first protrusion part are same.

13. The electronic device (201) of claim 2**,** wherein the first conductive area (2316) is configured to perform a function of an antenna.

14. The electronic device (201) of claim 13, further comprising:
a second reinforcedstructure (321) formed at a part of the second conductive area (2317) adjacent to the non-conductive area,
wherein the second reinforcedstructure (321) comprises a second protrusion part protruding towards the space between the front surface (210) and the rear surface (220), and having the first height.

15. The housing (200) of claim 1**,**
wherein the first part (611) is formed at a first placement height from a plane of the rear surface, and
wherein the second part (611) is formed at a second placement height different from the first placement height from the plane of the rear surface.

## Patentansprüche

1. Gehäuse (200) für eine elektronische Vorrichtung (201), das Folgendes umfasst:
eine Vorderseite (210) der elektronischen Vorrichtung, eine Rückseite (220) der elektronischen Vorrichtung und eine Seitenfläche (230), die einen Raum zwischen der Vorderseite und der Rückseite umgibt,
wobei die Seitenfläche Folgendes umfasst:
einen ersten leitfähigen Bereich (2316) und einen zweiten leitfähigen Bereich (2317), die aus einem leitfähigen Material gebildet sind;
einen nicht leitfähigen Bereich (2324), der aus einem nicht leitfähigen Material gebildet ist;
eine erste verstärkte Struktur (311), die an einem Teil des ersten leitfähigen Bereichs (430) ausgebildet ist und einen ersten Vorsprungsteil umfasst, der in Richtung des Raums zwischen der Vorderseite (210) und der Rückseite (220) vorsteht,
wobei der erste Vorsprungsteil einen ersten Teil (611) mit einer ersten Höhe und einen zweiten Teil (613) mit einer zweiten Höhe enthält, die sich von der ersten Höhe unterscheidet.

2. Elektronische Vorrichtung (201), die Folgendes umfasst:
ein Display (252); und
ein Gehäuse (200) nach Anspruch 1, in dem das Display (252) angeordnet ist und das eine Außenseite der elektronischen Vorrichtung (201) bildet.

3. Elektronische Vorrichtung (201) nach Anspruch 2,
wobei die erste Höhe und die zweite Höhe unterschiedlich sind, wenn in einer ersten Richtung, in die das Display (252) zeigt, oder in einer zweiten Richtung entgegengesetzt zu der ersten Richtung betrachtet.

4. Elektronische Vorrichtung (201) nach Anspruch 2,
wobei eine erste Öffnung für die Einspritzung (313) und eine zweite Öffnung für die Einspritzung (323) an dem ersten Vorsprungsteil und dem zweiten Vorsprungsteil ausgebildet sind,
wobei die erste Öffnung für die Einspritzung (313) und die zweite Öffnung für die Einspritzung (323) den ersten Vorsprungsteil und den zweiten Vorsprungsteil in der ersten Richtung, in die das Display zeigt, oder in der zweiten Richtung entgegengesetzt zu der ersten Richtung durchdringen, und
wobei die erste Öffnung (313) und die zweite Öffnung für die Einspritzung (323) so konfiguriert sind, dass sie mit dem nicht leitfähigen Material gefüllt werden.

5. Elektronische Vorrichtung (201) nach Anspruch 2, die ferner Folgendes umfasst:
eine leitfähige Struktur (701),
wobei der erste Teil (611) des ersten Vorsprungsteils und der zweite Teil (613) des ersten Vorsprungsteils jeweils auf einer ersten Platzierungshöhe und einer zweiten Platzierungshöhe ausgebildet sind, so dass der erste Teil (611) des ersten Vorsprungsteils und der zweite Teil (611) des ersten Vorsprungsteils um mindestens einen Abstand von der leitfähigen Struktur beabstandet sind.

6. Elektronische Vorrichtung (201) nach Anspruch 5,
wobei, wenn die leitfähige Struktur näher an dem ersten Teil (611) des ersten Vorsprungsteils als an dem zweiten Teil (613) des ersten Vorsprungsteils liegt und wenn die leitfähige Struktur an einer Position angeordnet ist, die höher als die erste Platzierungshöhe ist, der zweite Teil (613) des ersten Vorsprungsteils an einer zweiten Platzierungsposition ausgebildet ist, die höher als die erste Platzierungshöhe ist.

7. Elektronische Vorrichtung (201) nach Anspruch 5,
wobei, wenn die leitfähige Struktur näher an dem ersten Teil (611) des ersten Vorsprungsteils als an dem zweiten Teil (613) des ersten Vorsprungsteils liegt und wenn die leitfähige Struktur an einer Position angeordnet ist, die niedriger als die erste Platzierungshöhe ist, der zweite Teil (613) des ersten Vorsprungsteils an einer zweiten Platzierungsposition ausgebildet ist, die niedriger als die erste Platzierungshöhe ist.

8. Elektronische Vorrichtung (201) nach Anspruch 2,
wobei der erste Teil (611) des ersten Vorsprungsteils und/oder der zweite Teil (613) des ersten Vorsprungsteils eine geneigte Oberfläche umfassen,
wobei die geneigte Oberfläche, wenn in einer ersten Richtung, in die das Display zeigt, oder in einer zweiten Richtung entgegengesetzt zu der ersten Richtung betrachtet, um einen Winkel in Bezug auf eine Anzeigefläche des Displays geneigt ist.

9. Elektronische Vorrichtung (201) nach Anspruch 2,
wobei sich der erste Teil (611) des ersten Vorsprungsteils und der zweite Teil (613) des ersten Vorsprungsteils in Anzahl, Höhe, Breite und/oder Tiefe unterscheiden.

10. Elektronische Vorrichtung (201) nach Anspruch 4,
wobei die erste Öffnung für die Einspritzung (313) und die zweite Öffnung für die Einspritzung (323) an dem ersten Teil (611) des ersten Vorsprungsteils und dem zweiten Teil (613) des ersten Vorsprungsteils in Anzahl, Größe und/oder Form unterschiedlich ausgebildet sind.

11. Elektronische Vorrichtung (201) nach Anspruch 2,
wobei der erste Teil (611) des ersten Vorsprungsteils und/oder der zweite Teil (613) des ersten Vorsprungsteils eine äußere Umfangsfläche umfassen, in der eine Öffnung ausgebildet ist.

12. Elektronische Vorrichtung (201) nach Anspruch 3,
wobei das Gehäuse durch Einspritzen des nicht leitfähigen Materials in eine leitfähige Platte mit einer Einsatzform gebildet ist, und
wobei, wenn in erster Richtung betrachtet, eine Höhe einer Einspritzgrenze, die dem ersten Teil (611) des ersten Vorsprungsteils entspricht, und eine Höhe einer Einspritzgrenze, die dem zweiten Teil (613) des ersten Vorsprungsteils entspricht, gleich sind.

13. Elektronische Vorrichtung (201) nach Anspruch 2,
wobei der erste leitfähige Bereich (2316) so konfiguriert ist, dass er die Funktion einer Antenne ausführt.

14. Elektronische Vorrichtung (201) nach Anspruch 13, die ferner Folgendes umfasst:
eine zweite verstärkte Struktur (321), die an einem Teil des zweiten leitfähigen Bereichs (2317) neben dem nicht leitfähigen Bereich ausgebildet ist,
wobei die zweite verstärkte Struktur (321) einen zweiten Vorsprungsteil umfasst, der in Richtung des Raums zwischen der Vorderseite (210) und der Rückseite (220) vorsteht und die erste Höhe aufweist.

15. Gehäuse (200) nach Anspruch 1,
wobei der erste Teil (611) in einer ersten Platzierungshöhe von einer Ebene der Rückseite ausgebildet ist, und
wobei der zweite Teil (611) in einer zweiten Platzierungshöhe, die sich von der ersten Platzierungshöhe unterscheidet, von der Ebene der Rückseite ausgebildet ist.

## Revendications

1. Boîtier (200) pour un dispositif électronique (201) comprenant :
une surface avant (210) du dispositif électronique, une surface arrière (220) du dispositif électronique et une surface latérale (230) entourant un espace entre la surface avant et la surface arrière,
où la surface latérale comprend :
une première zone conductrice (2316) et une deuxième zone conductrice (2317) formées avec un matériau conducteur ;
une zone non conductrice (2324) formée avec un matériau non conducteur ;
une première structure renforcée (311) formée au niveau d'une partie de la première zone conductrice (430) et comprenant une première partie en saillie faisant saillie vers l'espace entre la surface avant (210) et la surface arrière (220),
où la première partie en saillie inclut une première partie (611) ayant une première hauteur et une deuxième partie (613) ayant une deuxième hauteur différente de la première hauteur.

2. Dispositif électronique (201) comprenant :
un écran (252) ; et
un boîtier (200) selon la revendication 1, dans lequel l'écran (252) est placé, formant un extérieur du dispositif électronique (201).

3. Dispositif électronique (201) selon la revendication 2,
où la première hauteur et la deuxième hauteur sont différentes lorsqu'elles sont vues dans une première direction où l'écran (252) est orienté ou dans une deuxième direction opposée à la première direction.

4. Dispositif électronique (201) selon la revendication 2,
où une première ouverture pour injection (313) et une deuxième ouverture pour injection (323) sont formées au niveau de la première partie en saillie et de la deuxième partie en saillie,
où la première ouverture pour injection (313) et la deuxième ouverture pour injection (323) traversent la première partie en saillie et la deuxième partie en saillie dans la première direction où l'écran est orienté ou dans la deuxième direction opposée à la première direction, et
où la première ouverture (313) et la deuxième ouverture pour injection (323) sont configurées pour être remplies avec le matériau non conducteur.

5. Dispositif électronique (201) selon la revendication 2, comprenant en outre :
une structure conductrice (701),
où la première partie (611) de la première partie en saillie et la deuxième partie (613) de la première partie en saillie sont formées respectivement à une première hauteur de placement et à une deuxième hauteur de placement de telle sorte que la première partie (611) de la première partie en saillie et la deuxième partie (611) de la première partie en saillie sont espacées de la structure conductrice d'au moins une distance.

6. Dispositif électronique (201) selon la revendication 5,
où, lorsque la structure conductrice est plus adjacente à la première partie (611) de la première partie en saillie qu'à la deuxième partie (613) de la première partie en saillie et lorsque la structure conductrice est placée à une position plus élevée que la première hauteur de placement, la deuxième partie (613) de la première partie en saillie est formée à une deuxième position de placement plus élevée que la première hauteur de placement.

7. Dispositif électronique (201) selon la revendication 5,
où, lorsque la structure conductrice est plus adjacente à la première partie (611) de la première partie en saillie qu'à la deuxième partie (613) de la première partie en saillie et lorsque la structure conductrice est placée à une position plus basse que la première hauteur de placement, la deuxième partie (613) de la première partie en saillie est formée à une deuxième position de placement plus basse que la première hauteur de placement.

8. Dispositif électronique (201) selon la revendication 2,
où au moins l'une parmi la première partie (611) de la première partie en saillie et la deuxième partie (613) de la première partie en saillie comprend une surface inclinée,
où la surface inclinée, lorsqu'elle est vue dans une première direction où l'écran est orienté ou dans une deuxième direction opposée à la première direction, est inclinée d'un angle par rapport à une surface d'affichage de l'écran.

9. Dispositif électronique (201) selon la revendication 2,
où la première partie (611) de la première partie en saillie et la deuxième partie (613) de la première partie en saillie sont différentes en au moins l'un parmi des nombres, des hauteurs, des largeurs ou des profondeurs.

10. Dispositif électronique (201) selon la revendication 4,
où la première ouverture pour injection (313) et la deuxième ouverture pour injection (323) sont formées différemment au niveau de la première partie (611) de la première partie en saillie et de la deuxième partie (613) de la première partie en saillie en au moins l'un parmi des nombres, des tailles ou des formes.

11. Dispositif électronique (201) selon la revendication 2,
où au moins l'une parmi la première partie (611) de la première partie en saillie et la deuxième partie (613) de la première partie en saillie comprend une surface périphérique extérieure où une ouverture est formée.

12. Dispositif électronique (201) selon la revendication 3,
où le boîtier est formé en injectant le matériau non conducteur dans une plaque conductrice à l'aide d'un moulage par insertion, et
où, lorsqu'elles sont vues dans la première direction, une hauteur d'une limite d'injection correspondant à la première partie (611) de la première partie en saillie et une hauteur d'une limite d'injection correspondant à la deuxième partie (613) de la première partie en saillie sont identiques.

13. Dispositif électronique (201) selon la revendication 2,
où la première zone conductrice (2316) est configurée pour effectuer une fonction d'une antenne.

14. Dispositif électronique (201) selon la revendication 13, comprenant en outre :
une deuxième structure renforcée (321) formée au niveau d'une partie de la deuxième zone conductrice (2317) adjacente à la zone non conductrice,
où la deuxième structure renforcée (321) comprend une deuxième partie en saillie faisant saillie vers l'espace entre la surface avant (210) et la surface arrière (220), et ayant la première hauteur.

15. Boîtier (200) selon la revendication 1,
où la première partie (611) est formée à une première hauteur de placement à partir d'un plan de la surface arrière, et
où la deuxième partie (611) est formée à une deuxième hauteur de placement différente de la première hauteur de placement à partir du plan de la surface arrière.
